# FASCICULE DE BREVET EUROPEEN

(11) **EP 1 788 635 B1**
(45) Date de publication et mention de la délivrance du brevet: **16.07.2008**
(21) Numéro de dépôt: 06124271.5
(22) Date de dépôt: 17.11.2006
(51) Int. Cl.: H01L 29/786, H01L 21/336

(54) **Procédé de réalisation de transistor à double grilles auto-alignées par réduction de motifs de grille**
Verfahren zum Herstellen eines Transistors mit selbst justierten Doppel-Gates durch Schrumpfung der Gatestruktur
Method of manufacturing a self-aligned dual-gates transistor through gate pattern reduction

(30) Priorité: 18.11.2005 FR 0553510
(43) Date de publication de la demande: 23.05.2007
(60) Demande divisionnaire: 07118245.5
(73) Titulaire: Commissariat à l'Energie Atomique, 75015 Paris (FR)
(72) Inventeur: Licitra, Christophe, 38100, GRENOBLE (FR); Vinet, Maud, 38140, RIVES (FR)
(74) Mandataire: Poulin, Gérard

(56) Documents cités:
- WO-A-03/075355
- US-A1- 2002 081 791
- US-A1- 2004 016 968
- JONG-HO LEE ET AL: "Super self-aligned double-gate (SSDG) MOSFETs utilizing oxidation rate difference and selective epitaxy" ELECTRON DEVICES MEETING, 1999. IEDM TECHNICAL DIGEST. INTERNATIONAL WASHINGTON, DC, USA 5-8 DEC. 1999, PISCATAWAY, NJ, USA,IEEE, US, 5 décembre 1999 (1999-12-05), pages 71-74, XP010372016 ISBN: 0-7803-5410-9

## Description

### DOMAINE TECHNIQUE ET ART ANTÉRIEUR

La présente invention se rapporte au domaine des circuits intégrés, et plus particulièrement à celui des transistors, et a pour but de présenter un dispositif microélectronique doté d'au moins une structure de double grille pour un transistor. L'invention met en particulier en oeuvre un procédé amélioré de réalisation de transistors à double-grille.

Une structure classique de transistor est généralement formée, sur un substrat, par exemple de type SOI (SOI pour « silicon on insulator » ou « silicium sur isolant »), d'une région de source et d'une région de drain, par exemple sous forme respectivement d'une première et d'une deuxième zones semi-conductrices, reliées entre elles par une troisième structure semi-conductrice destinée à jouer le rôle d'un canal ou de plusieurs canaux dans le(s)quel(s) un courant est destiné à circuler, et qui peut avoir une forme d'un bloc ou d'un barreau, ou éventuellement de plusieurs barreaux semi-conducteurs disjoints. Ce barreau ou ces barreaux semi-conducteurs sont recouverts d'une grille semi-conductrice ou métallique permettant de contrôler l'intensité d'un courant transitant dans le canal ou éventuellement dans les canaux entre la région de source et la région de drain.

Pour améliorer notamment le contrôle de la conduction du canal, de nouvelles structures de grilles de transistor sont apparues. Parmi ces nouvelles structures, la structure dite de « double-grille » est formée d'une première couche de matériau de grille située sous une zone semi-conductrice de canal de transistor, et une deuxième couche de matériau de grille située sur la zone semi-conductrice de canal de transistor.

Le document WO 03/075355 A1 présente un procédé de réalisation d'une structure de double grille, comprenant la formation d'une structure factice de double-grille, formée d'un motif de grille factice à base de matériau isolant, et d'un autre motif de grille factice à base de matériau isolant, puis le retrait dudit matériau isolant et son remplacement par un diélectrique de grille puis par un matériau de grille. Les étapes de dépôt du diélectrique de grille et du matériau de grille rendent la réalisation de grilles de mêmes dimensions dans la structure double-grille délicate. En outre, avec un tel procédé, les grilles de la structure double-grille sont à base du même matériau.

Le document de Lee J-H., Taraschi G., Wei A., Langdo T.A., Fitzgerald E. A., Antoniadis D.A., "Super Self-Aligned Double-Gate (SSDG) MOSFETs Utilising Oxidation Rate Difference and Selective Epitaxy", IEDM pp.71-74 » présente quant à lui un procédé de formation d'une structure double grille pour un transistor, comprenant la formation sur un substrat d'un empilement doté d'une première couche de matériau de grille, d'une première couche de diélectrique de grille, d'une couche semi-conductrice dans laquelle le canal est destiné à être réalisé, d'une deuxième couche de diélectrique de grille et d'une deuxième couche de matériau de grille. Une gravure de l'empilement à travers un masquage est ensuite réalisée pour former les motifs de la double grille. Puis, pour réaliser des espaceurs, on effectue une oxydation différentielle entre les motifs de grilles par exemple en polysilicium et la zone semi-conductrice de canal par exemple en silicium, suivie d'une désoxydation contrôlée pour dévoiler la zone semi-conductrice de canal. Ce procédé comprend une étape d'oxydation haute température susceptible de dégrader les matériaux de grille. Par ailleurs, il est délicat d'effectuer une désoxydation de la zone semi-conductrice de canal sans retirer l'oxyde des espaceurs formés de part et d'autre des grilles.

Le document WO 03/103035 divulgue également un procédé de réalisation d'une structure de double-grille pour un transistor. Ce procédé comprend notamment une étape de formation d'une première grille que l'on appellera grille « inférieure », dans une couche de matériau de grille d'un empilement comprenant également une couche semi-conductrice dans laquelle un canal est destiné à être réalisé, une deuxième couche de matériau de grille, une couche isolante. Ensuite, une étape de formation d'une zone de canal dans la couche semi-conductrice et d'un motif dans la couche isolante, en utilisant la grille inférieure comme masque, est effectuée. Un collage-retournement de supports, puis un retrait dudit motif formé dans la couche isolante, et son remplacement par un matériau de grille, sont également réalisés lors de ce procédé. Ce procédé comprend également une étape d'élimination sélective d'une couche de silicium avec arrêt sur une couche de polysilicium non dopé, difficile à mettre en oeuvre.

Le document US 6 365 465 présente quant à lui un procédé de réalisation d'une structure de double grille de transistor comprenant la formation d'une structure de canal suspendu, par exemple en silicium, entre des zones de source et drain, puis une photolithographie pour définir des grilles supérieure et inférieure d'une structure double grille. Avec un tel procédé, la grille inférieure et la grille supérieure ont des dimensions critiques différentes, la taille de la grille inférieure étant égale à l'espace entre source et drain moins deux fois l'épaisseur de l'isolant de grille tandis que la taille de la grille supérieure est égale à la taille du niveau de lithographie grille. La structure de transistor obtenue à l'aide d' un tel procédé comporte des zones de source et drain, isolées des grilles uniquement par le diélectrique de grille et ne donne pas la possibilité de former des espaceurs. Il est également difficile de pouvoir réduire les motifs de grilles et d'obtenir de faible dimension critique avec un tel procédé.

Le document JP-A-2001-102590 divulgue un procédé de réalisation d'une structure de grille de transistor comprenant : la formation par photolithographie d'une première grille à l'aplomb d'une zone semi-conductrice de canal puis de réalisation d'une grille supérieure à l'aide d'une deuxième photolithographie. Cette approche a pour inconvénients de former deux grilles de tailles différentes, et de rendre difficile, l'alignement desdites deux grilles, en particulier lorsque les dimensions critiques deviennent très faibles par exemple inférieures à 20 nm.

Le document FR 2 829 294 divulgue également un procédé de réalisation d'une structure de double grille de transistor ainsi qu'une pluralité d'espaceurs, notamment pour protéger la grille supérieure lors de la gravure du canal, pour protéger le canal lors de la gravure de la grille inférieure, et pour isoler la grille inférieure des régions de source et drain. Les grilles supérieure et inférieure mises en oeuvre à l'aide d'une tel procédé ont des tailles différentes.

Il se pose le problème de trouver un nouveau procédé de réalisation d'une structure double grille pour transistor, qui ne présente pas les inconvénients mentionnés ci-dessus.

### EXPOSÉ DE L'INVENTION

La présente invention a pour but de présenter un dispositif microélectronique comprenant au moins un transistor doté d'une structure de double grille, comprenant une première grille ou « grille inférieure » située sous une zone de canal du transistor, une deuxième grille ou « grille supérieure » située sur une zone de canal du transistor, la première grille et la deuxième grille ayant des dimensions critiques respectives égales ou sensiblement égales ou proches et inférieures à la dimension critique du canal. Par dimensions critiques « sensiblement égales » ou « proches » on entend des dimensions qui ne diffèrent pas de plus de 2 nanomètres. On entendra tout au long de la présente description par « dimension critique » ou « côte minimale », la dimension minimale d'un motif géométrique réalisé dans une couche mince, hormis la ou les dimensions définies par l'épaisseur de cette couche mince.

L'invention concerne un procédé de réalisation d'un dispositif microélectronique doté d'au moins une structure de double grille pour transistor, comprenant les étapes de :
a) formation d'au moins un empilement comprenant au moins une première couche de matériau(x) de grille, au moins une première couche de diélectrique de grille reposant sur la première couche de matériau(x) de grille, au moins une zone semi-conductrice reposant sur ladite première couche de diélectrique de grille, au moins une deuxième couche de diélectrique de grille reposant sur ladite zone semi-conductrice et sur ladite première couche de diélectrique de grille, et au moins une deuxième couche de matériau(x) de grille reposant sur la deuxième couche de diélectrique de grille,
b) gravure, par exemple anisotrope, dudit empilement à travers un masquage, de manière à réaliser en regard de la zone semi-conductrice, au moins une première structure comportant une zone semi-conductrice dite « de canal » formée à partir de ladite zone semi-conductrice gravée, au moins un premier motif d'une première grille formé à partir de la première couche de matériau de grille gravée, et au moins un deuxième motif d'une deuxième grille formée à partir de la deuxième couche de matériau de grille gravée,
c) gravure, par exemple isotrope, d'au moins une partie du premier motif et d'au moins une partie du deuxième motif, sélective vis-à-vis de la zone semi-conductrice de canal.

La gravure isotrope à l'étape c) est réalisée de manière à réduire le premier motif de grille et le deuxième motif de grille. A la suite de l'étape b), le premier motif de la première grille, le deuxième motif de la deuxième grille et la zone semi-conductrice formées, ont des dimensions critiques égales ou sensiblement égales. A la suite de l'étape c), le premier motif de la première grille, le deuxième motif de la deuxième grille ont des dimensions critiques respectives inférieures à celles de la zone semi-conductrice de canal.

Selon une possibilité, ladite première couche de matériaux de grille peut être formée d'un empilement de plusieurs sous-couches de matériaux différents.

Ledit empilement peut comprendre par exemple au moins un matériau susceptible d'être gravé sélectivement par rapport à la zone semi-conductrice et au moins un autre matériau choisi pour ses propriétés de conduction de l'électricité. Cela peut permettre de former des motifs de grille de dimension critique réduits par rapport à la zone semi-conductrice de canal, tout en ayant un bon contrôle de la grille.

Selon une mise en oeuvre possible ladite deuxième couche de matériaux de grille peut être formée d'un empilement de plusieurs sous-couches de matériaux différents.

Selon une variante dans laquelle ladite première couche de matériaux de grille est formée d'un premier empilement de plusieurs sous-couches de matériaux différents et la deuxième couche de matériaux de grille est formée d'un deuxième empilement de plusieurs sous-couches de matériaux différents, le premier empilement peut être différent du deuxième empilement ou/et peut comprendre au moins un matériau différent de celui du premier empilement. Dans un cas où le premier empilement est formé d'un ou plusieurs matériaux différents de ceux du deuxième empilement on peut former une grille inférieure et une grille supérieure dotées des caractéristiques électriques différentes tout en ayant une dimension critique inférieure à celle de la zone semi-conductrice de canal.

Selon une autre possibilité, le premier empilement et le deuxième empilement peuvent être formés des mêmes matériaux mais avoir des agencements différents. Le premier empilement et le deuxième empilement peuvent être formés respectivement d'un empilement de deux couches dit « premier bicouches » et d'un autre empilement de deux couches dit « deuxième bicouches », le deuxième bicouches étant formé des mêmes matériaux que le premier bicouches mais ayant un agencement différent de celui du premier bicouches.

La première couche de matériau(x) de grille ou/et la deuxième couche de matériau(x) de grille peuvent comprendre au moins un matériau semi-conducteur.

Selon une possibilité, la gravure isotrope à l'étape c) peut comprendre au moins une étape de gravure sèche dudit matériau semi-conducteur à l'aide d'un plasma.

Selon une mise en oeuvre particulière ledit matériau semi-conducteur peut être du polySiGe.

La première couche de matériau(x) de grille ou/et la deuxième couche de matériaux de grille peuvent comprendre au moins une sous-couche à base d'au moins un matériau métallique.

Le matériau métallique peut être choisi par exemple parmi l'un des matériaux suivants : Ti, TiN, W, WN, Ta, TaN.

Selon une possibilité, la gravure isotrope à l'étape c) peut comprendre au moins une étape de gravure humide, à l'aide d'une solution de type SC2 (SC2 pour « standard clean 2 » selon la terminologie anglo-saxonne) à base de HC1 + H₂O₂ + H₂O de ladite ou desdites sous-couches à base de matériau métallique.

Selon une possibilité, ladite zone semi-conductrice peut être à base de silicium.

L'étape b) de gravure anisotrope peut comprendre en outre : la réalisation d'au moins une deuxième structure en regard d'une zone ou dans une zone de l'empilement dans laquelle la deuxième couche de diélectrique de grille repose sur la première couche de diélectrique de grille, la deuxième structure comportant au moins un troisième motif, relié audit premier motif, et formé de la première couche de matériau(x) de grille gravée et au moins un quatrième motif, relié audit deuxième motif, et formé de la deuxième couche de matériau(x) de grille gravée, le troisième motif et le quatrième motif étant séparés par l'intermédiaire des couches de diélectriques de grille. Ladite deuxième structure est reliée à la première structure et peut être destinée à servir de zones prises de contacts pour la première grille et pour la deuxième grille.

Le procédé suivant l'invention peut comprendre également, par exemple après la réalisation de zones de source et de drain, une réalisation sur ladite deuxième structure d'au moins un premier contact métallique en contact avec ledit troisième motif sans être en contact avec ledit quatrième motif, et au moins un deuxième contact métallique en contact avec le quatrième motif sans être en contact avec ledit troisième motif.

Le procédé peut éventuellement comprendre en outre, après l'étape c), la formation de blocs isolants ou d'espaceurs isolants de part et d'autre du premier motif de la première grille et de part et d'autre du deuxième motif de la deuxième grille.

La réalisation desdits espaceurs isolants peut éventuellement comprendre les étapes de :
- formation au moins sur la première structure d'au moins une couche à base d'un premier matériau isolant,
- formation sur le premier matériau isolant d'au moins un deuxième matériau isolant,
- gravure anisotrope du deuxième matériau isolant,
- retrait partiel du premier matériau isolant, de manière à dévoiler la zone semi-conductrice de canal.

Le procédé peut comprendre en outre, après l'étape c), la formation d'au moins une première zone destinée à jouer le rôle de région de source, en contact avec la zone semi-conductrice de canal, et d'au moins une deuxième zone, destinée à jouer le rôle de région de drain, en contact avec la zone semi-conductrice de canal.

Selon une variante, la formation de ladite première zone et de ladite deuxième zone peut comprendre une croissance par épitaxie de blocs semi-conducteurs sur les flancs de la zone semi-conductrice de canal. Dans ce cas, les blocs semi-conducteurs peuvent être avantageusement à base d'un matériau semi-conducteur différent de celui ou de ceux de la zone semi-conductrice de canal.

Selon une deuxième variante, la formation de ladite première zone de région de source et de ladite deuxième zone de région de drain peut comprendre les étapes de :
- dépôt d'au moins une couche sur le support, sur la première structure, et éventuellement sur ladite deuxième structure,
- réalisation dans ladite couche de cavités de part et d'autre de ladite première structure,
- dépôt d'un ou plusieurs matériaux métalliques dans les cavités, de manière à former au moins un premier bloc métallique et au moins un deuxième bloc métallique de part et d'autre de la zone semi-conductrice de canal.

Selon une troisième variante, la formation de ladite première zone de région de source et de ladite deuxième zone de région de drain peut comprendre les étapes de :
- croissance par épitaxie d'au moins un premier bloc semi-conducteurs et d'au moins un deuxième blocs semi-conducteur, respectivement sur les flancs de la zone semi-conductrice de canal,
- dépôt d'au moins une couche dite « de protection » sur le support,
- réalisation dans la couche de protection de cavités de part et d'autre de ladite première structure,
- dépôt d'un ou plusieurs matériaux métalliques dans les cavités, de manière à former, de part et d'autre de la zone semi-conductrice de canal, au moins un premier bloc métallique en contact avec le premier bloc semi-conducteur et au moins un deuxième bloc métallique en contact avec le deuxième bloc semi-conducteur.

La formation dudit empilement à l'étape a), peut comprendre des étapes de :
- dépôt de la première couche de diélectrique de grille sur une couche semi-conductrice reposant sur une couche isolante recouvrant un premier support,
- dépôt de la première couche de matériau(x) de grille sur ladite première couche de diélectrique de grille,
- collage d'un deuxième support sur la première couche de matériau(x) de grille,
- retrait du premier support et d'une partie de ladite couche isolante recouvrant le premier support,
- gravure de ladite couche semi-conductrice de manière à former ladite zone semi-conductrice,
- dépôt de la deuxième couche de diélectrique de grille sur ladite zone semi-conductrice et sur la première couche de diélectrique de grille,
- dépôt de la deuxième couche de matériau(x) de grille sur la deuxième couche de diélectrique de grille.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A à 1T, et 2A-2E, et 3A-3I illustrent un premier exemple de procédé microélectronique selon l'invention,
- les figures 4A à 4E, illustrent une variante du premier exemple de procédé microélectronique selon l'invention,
- les figures 5A et 5B, illustrent une autre variante du premier exemple de procédé microélectronique selon l'invention,
- les figures 6A à 6C, illustrent une autre variante du premier exemple de procédé microélectronique selon l'invention,
- les figures 7, 8A-8C, illustrent une variante de réalisation de zones de source et de drain pour un transistor à double grille mis en oeuvre selon l'invention,
- la figure 9 illustre une structure de prise de contacts pour une double grille mise en oeuvre selon l'invention,
- la figure 10, illustre un dispositif de transistor à double grille, doté d'un contact pour la grille supérieure de la double grille, et d'un autre contact pour la grille inférieure de la double grille, le contact de la grille supérieure n'étant pas relié ou en contact avec la grille inférieure, tandis que le contact de la grille inférieure n'est pas relié ou en contact avec la grille supérieure,

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

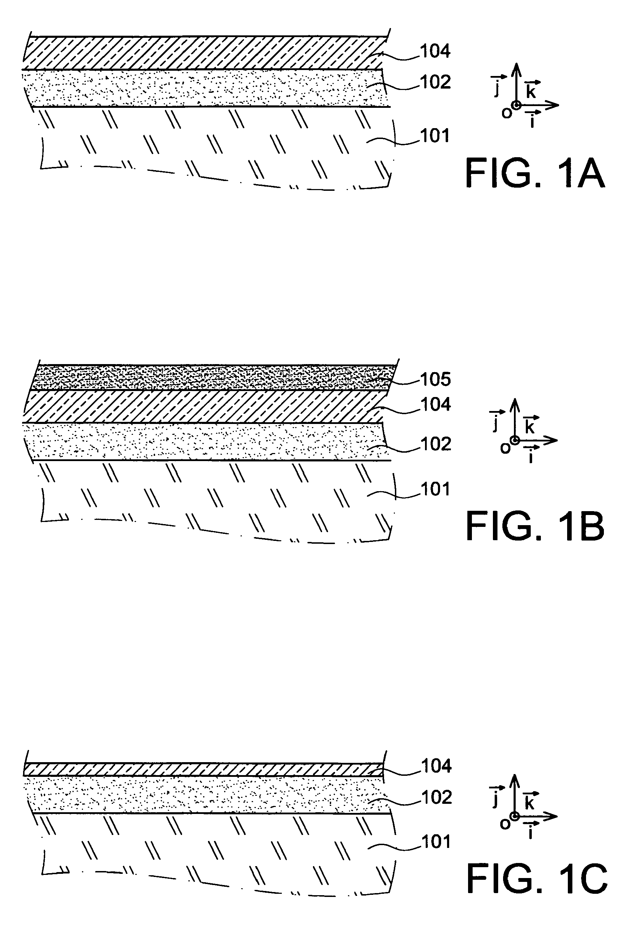

Un exemple de procédé suivant l'invention, de réalisation d'un dispositif microélectronique doté d'au moins une structure de double grille pour transistor, va à présent être donné en liaison avec les figures 1A-1T, et 2A-2E et 3A à 3I (les figures 1A-1T, 2A-2G, et 3A à 3I, représentant respectivement, le dispositif en cours de réalisation vu selon une première coupe X'X, ledit dispositif selon une vue de dessus, et ledit dispositif selon une deuxième coupe Y'Y, les coupes X'X et Y'Y étant réalisées dans des plans parallèles au plan [O ; *̅i̅*̅ ;*̅j̅*̅] d'un repère orthogonal [O ; *̅i̅*̅ ; *̅j̅*̅; *̅k̅*̅] indiqué sur les figures 1A-1T, 2A-2E et 3A-3I).

Le matériau de départ peut être par exemple un substrat, qui peut être de type semi-conducteur sur isolant, par exemple un substrat SOI (SOI pour « silicon on insulator » ou silicium sur isolant) ou un substrat germanium sur isolant (GeOI) ou SiGe sur isolant (SiGeOI). Le substrat peut comprendre une couche 101 que l'on appellera « premier support », par exemple à base d'un matériau semi-conducteur tel que du silicium, sur laquelle repose une couche isolante 102, par exemple une couche d'oxyde enterré (« burried oxide » selon la terminologie anglo-saxonne) à base de SiO₂, elle-même recouverte d'une couche semi-conductrice 104. La couche semi-conductrice 104 peut être par exemple à base de silicium, ou de germanium ou de SiGe (figure 1A).

Une étape d'amincissement de cette couche semi-conductrice 104 peut ensuite être effectuée, par exemple par oxydation du matériau semi-conducteur de la couche 104 afin de former une épaisseur 105 d'oxyde semi-conducteur, puis par retrait de cette épaisseur 105 d'oxyde, par exemple à l'aide de HF. La couche semi-conductrice 104 amincie peut avoir une épaisseur comprise par exemple entre 5 et 10 nanomètres (figures 1B et 1C).

Ensuite, on effectue le dépôt d'une couche de diélectrique 107 de grille, que l'on appellera « première couche de diélectrique de grille ». La couche diélectrique 107 peut avoir une épaisseur comprise par exemple 1 et 5 nanomètres et peut être par exemple à base d'un matériau dit de constante diélectrique élevée ou « high-k » selon la terminologie anglo-saxonne, par exemple du HfO₂ ou du Al₂O₃.

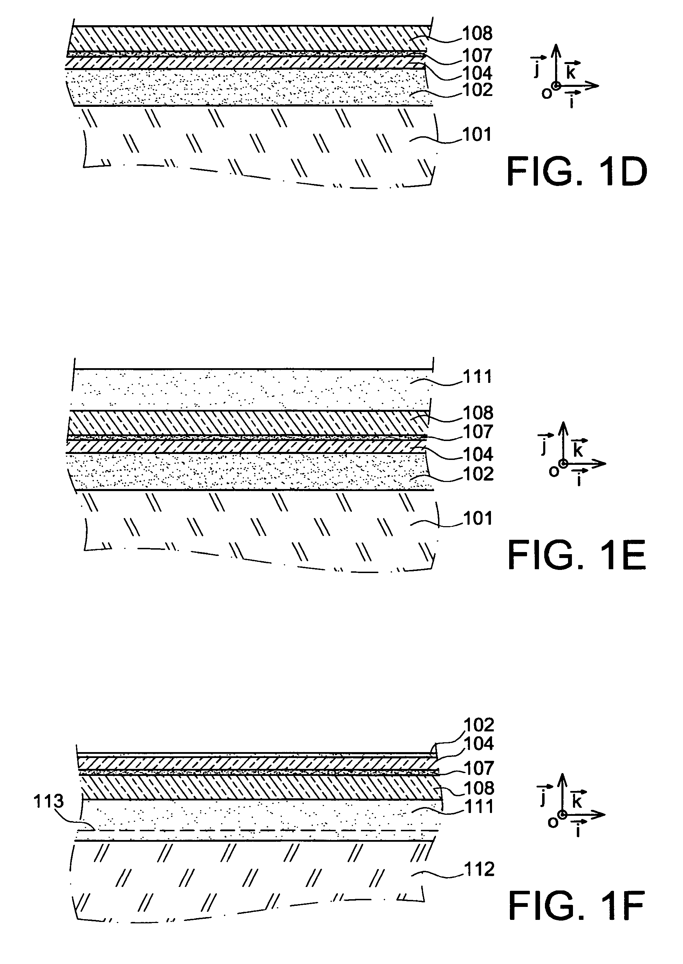

Puis, on effectue un dépôt d'une couche 108 de matériau de grille, que l'on nommera « première couche de matériau de grille ». Le matériau de grille utilisé pour former la couche 108, a été choisi de manière à pouvoir être gravé sélectivement par rapport à la couche semi-conductrice 104. La première couche de matériau de grille peut être à base par exemple d'un matériau semi-conducteur tel que du polySiGe, notamment dans un cas où la couche semi-conductrice est à base de Si (figure 1D).

On forme ensuite une autre couche isolante 111 dite « de collage », par exemple à base de SiO₂, sur la première couche 108 de matériau de grille (figure 1E). Puis on accole ou on colle un deuxième support sur la couche isolante 111, par exemple à l'aide d'un procédé de collage de type oxyde sur oxyde tel que présenté dans le document : « the bonding energy control : an original way to debondable substrate », Electrochemical society conf., Paris, Mai 2003 Wafer bonding Symposium ». Le deuxième support peut être formé par exemple d'une couche isolante (non référencée) reposant sur une autre couche 112, par exemple semi-conductrice.

On retire ensuite le premier support 101, par exemple à l'aide d'un polissage puis d'une attaque chimique à base de TMAH, ainsi qu'au moins une partie de l'épaisseur de la couche isolante 102 par exemple à l'aide de HF. Selon une possibilité de mise en oeuvre, l'interface 113 de collage entre la couche isolante 111 et la couche isolante du deuxième support peut être située par exemple à au moins 300 ou 350 ou 400 nanomètres de la couche 108 (figure 1F).

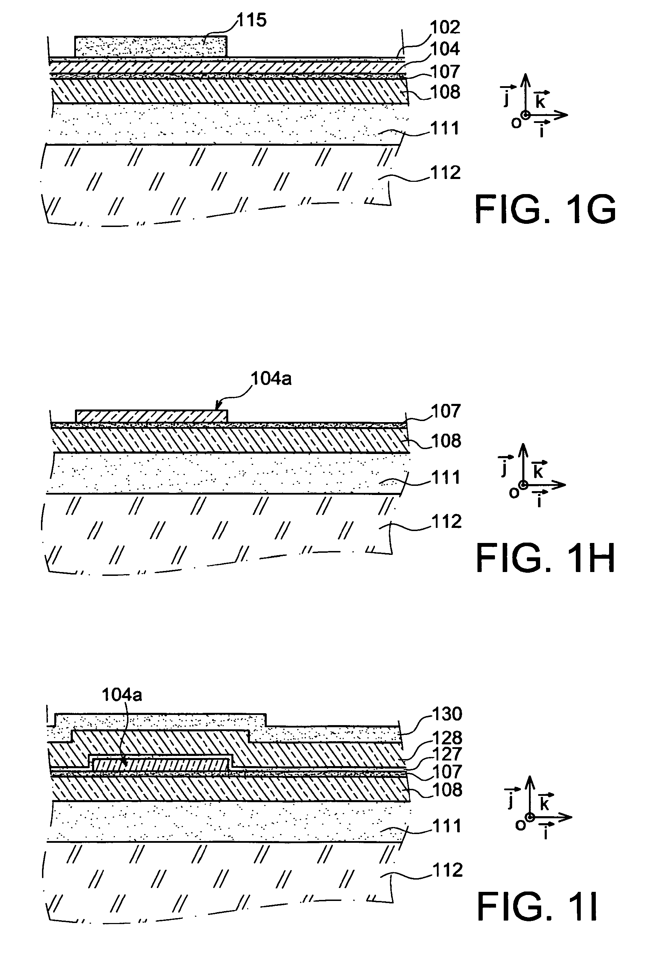

Ensuite, sur la couche isolante 102 et au dessus ou en regard de la couche semi-conductrice 104, on réalise un masquage comportant au moins un motif de zone active de transistor. Ce masquage peut être formé par exemple par dépôt d'une couche de résine 115 sur l'épaisseur restante de la couche isolante 102, puis formation, par exemple par photolithographie, du motif de zone active dans la couche de résine 115 (figure 1G).

Ensuite, on effectue une gravure de la couche semi-conductrice 104 et de la couche isolante 102 à travers le masquage, de manière reproduire le motif de zone active dans cette couche 104. La couche semi-conductrice gravée sera référencée 104a et nommée « zone semi-conductrice ». Dans au moins une partie de cette zone semi-conductrice 104a, un canal de transistor est destiné à être réalisé. Pour former la zone semi-conductrice 104a, une gravure anisotrope par exemple une gravure sèche par plasma à base de Cl₂ (+O₂) ou de HBr (+O₂) peut être effectuée à travers ledit masquage de résine 115, jusqu'au niveau de la première couche de diélectrique 107 de grille.

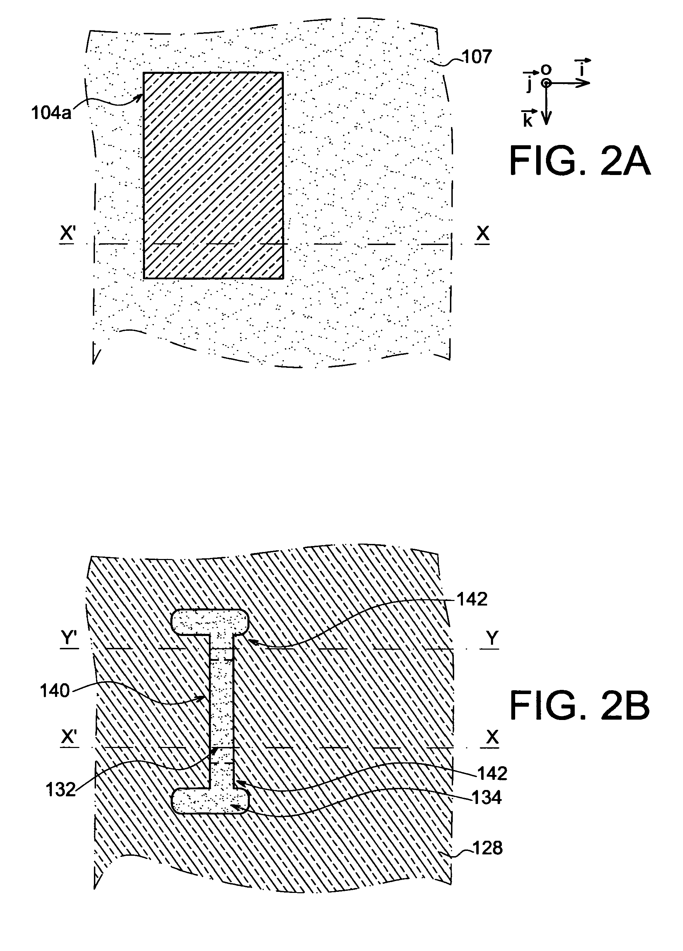

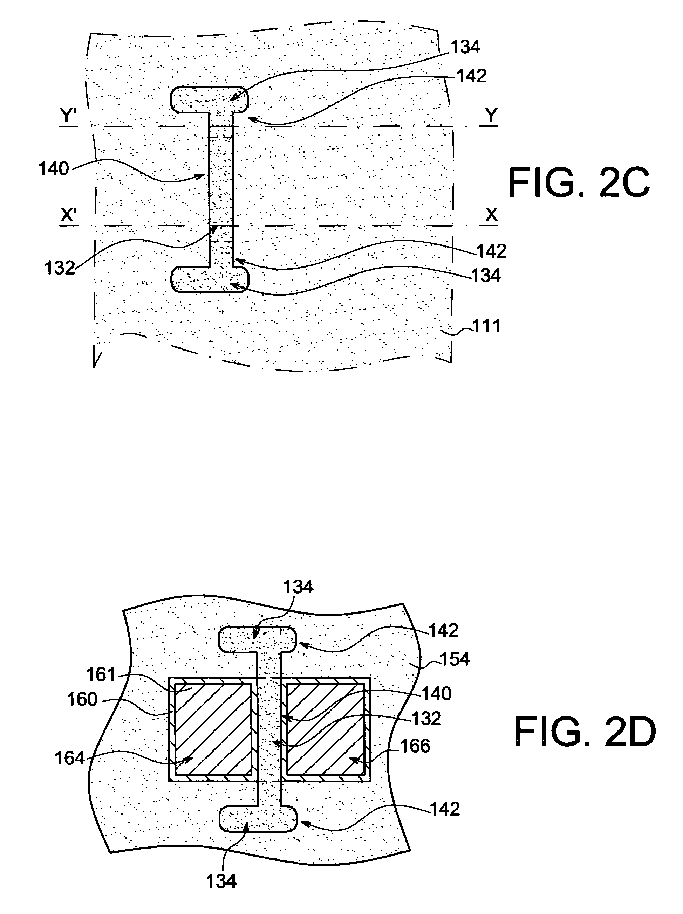

Le masquage 115 ainsi que la couche isolante 102 sont ensuite retirés. Le dispositif formé comporte alors en surface au moins une zone semi-conductrice 104a et au moins une zone dite « d'isolation » formée par la première couche de diélectrique 107 de grille (figures 2A et 1H, ces figures représentant respectivement, une vue du dessus du dispositif microélectronique en cours de réalisation, et une vue selon une coupe X'X de ce dispositif, la coupe X'X étant indiquée sur la figure 2A et réalisée dans un plan parallèle au plan [O ; *̅i̅*̅ ;*̅j̅*̅] du repère orthogonal [O ; *̅i̅*̅ ;*̅j̅*̅ ; *̅k̅*̅].

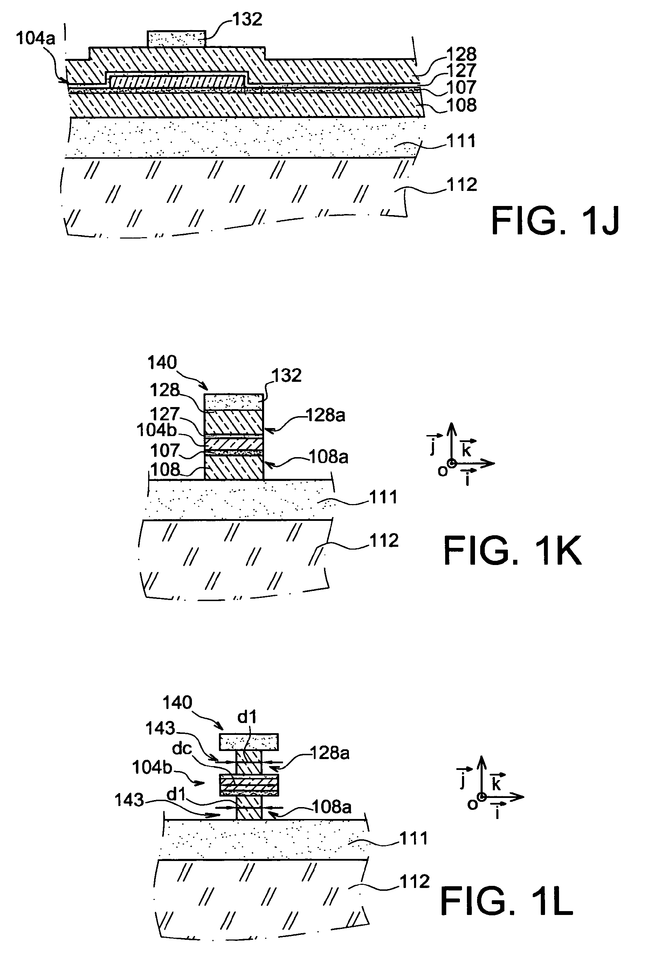

Ensuite, on dépose une autre couche 127 isolante dite « deuxième couche de diélectrique de grille » sur la zone semi-conductrice 104a et sur la couche diélectrique 107. Puis on dépose une couche de matériau de grille que l'on nommera « deuxième couche de matériau de grille ». La deuxième couche 128 de matériau de grille peut comprendre par exemple un matériau semi-conducteur. Le matériau de grille utilisé pour former la deuxième couche 128 de matériau de grille, a été choisi de manière à pouvoir être gravé sélectivement par rapport à la couche semi-conductrice 104. Dans un cas par exemple où la zone semi-conductrice 104a est à base de silicium, la deuxième couche 128 de matériau de grille peut être par exemple à base de polySiGe. Selon une possibilité de mise en oeuvre, la première couche 108 de matériau de grille et la deuxième couche 128 de matériau de grille peuvent avoir une composition identique ou/et être à base du même matériau. La première couche 108 de matériau de grille et la deuxième couche 128 de matériau de grille peuvent avoir également des épaisseurs égales ou sensiblement égales. On forme ensuite une autre couche de masquage 130 sur la deuxième couche 128 de matériau de grille (figure 1I) . L'autre couche de masquage 130 peut être par exemple à base de SiO₂. Puis, on réalise, par exemple par photolithographie, au moins un premier motif 132 en forme de grille dans une région de ladite autre couche de masquage 130 située en regard de la zone semi-conductrice 104a, et au moins un deuxième motif 134, relié au premier motif 132, et en forme d'une ou plusieurs zones de prise de contacts dans au moins une région de la couche de masquage 130 située en regard de la zone d'isolation 122. Selon une possibilité, le deuxième motif 134 peut être formé de deux parties de part et d'autre du premier motif (figures 1J, 2B et 3A, représentant respectivement une vue selon la coupe X'X, une vue de dessus, et une autre vue selon la coupe Y'Y du dispositif microélectronique en cours de réalisation).

On effectue ensuite une gravure à travers les motifs 132 et 134 de la couche de masquage, dans un empilement comprenant : la deuxième couche 128 de matériau de grille, la deuxième couche de diélectrique 127 de grille, la zone semi-conductrice 104a, la première couche de diélectrique 107 de grille, la première couche de matériau 108 de grille. La gravure dudit empilement est réalisée, de manière à reproduire la forme desdits motifs 132 et 134 dans ledit empilement et à dévoiler la couche isolante 111 de support. Ladite gravure de l'empilement peut être une gravure anisotrope réalisée par exemple à l'aide d'une gravure plasma, par exemple à base de Cl₂ (+ O₂) ou de HBr + (O₂) ou de BCl₃.

La zone semi-conductrice 104a gravée, sera à présent nommée zone semi-conductrice de canal et référencée 104b. Cette zone semi-conductrice de canal reproduit la forme ou le dessin du premier motif 132 de grille. Suite à la gravure de l'empilement, une première structure 140, comportant des motifs 108a, 128a d'une double grille respectivement sous et sur la zone semi-conductrice de canal 104b a été formée. Une deuxième structure 142, reliée à la première structure 140, et reproduisant le deuxième motif de zones de prises de contacts a également été formée et comprend des motifs 108b, 128b, à base respectivement de la première couche 108 de matériau de grille, et de la deuxième couche 128 de matériau de grille, séparés par des zones issues des couches diélectriques 107 et 127 (figures 1K, 2C, 3B, représentant respectivement, une vue selon la coupe X'X, une vue de dessus, et une autre vue selon la coupe Y'Y du dispositif microélectronique en cours de réalisation).

On effectue ensuite une gravure des motifs 108a, 128a, 108b, 128b, de matériau de grille sous les motifs 132 et 134 du masquage, sélective vis-à-vis de la zone semi-conductrice 104b de canal. Cette gravure peut être une gravure isotrope, par exemple une gravure sèche réalisée à l'aide d'un plasma. Un plasma à base de CF₄ peut être par exemple utilisé. Cette gravure isotrope permet d'effectuer une réduction latérale des motifs 108a, 108b, 128a, 128b, ou une réduction de la côte ou dimension critique des motifs 108a, 128a, de double grille, ainsi que celle des motifs 108b et 128b de la deuxième structure 142.

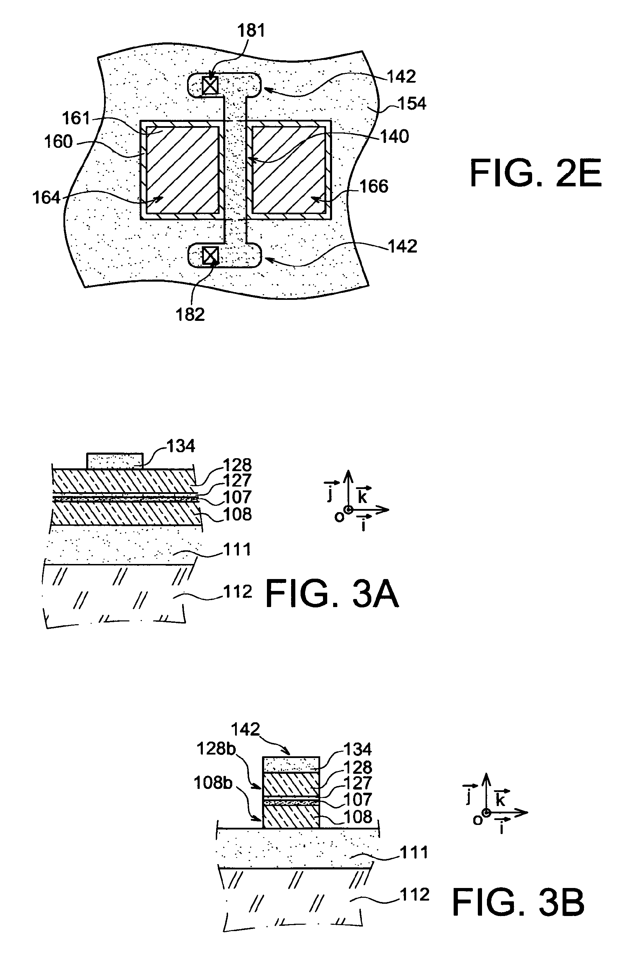

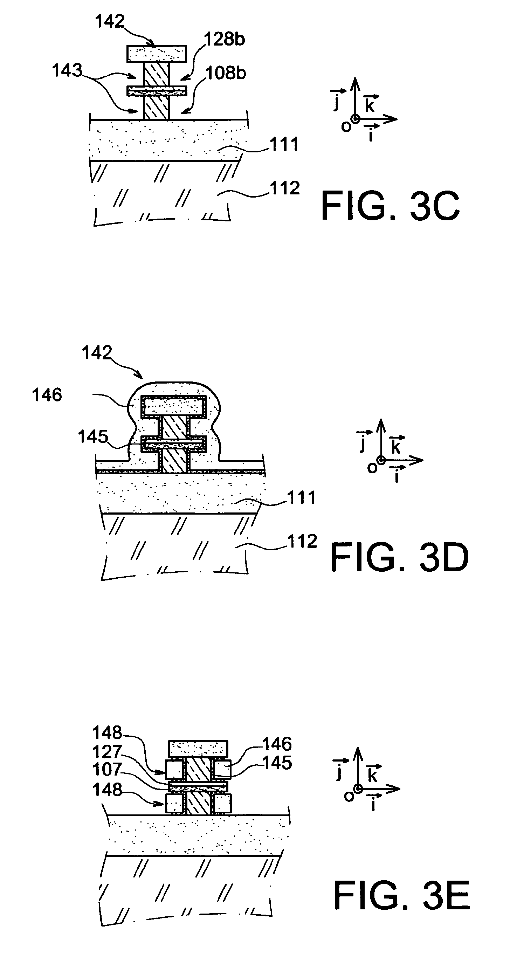

Après cette gravure isotrope, les motifs 108a, 128a, 108b, 128b, ont des côtes ou une dimension critiques respectives d₁ égales ou sensiblement égales (la dimension critique étant une dimension mesurée selon une direction parallèle à la direction définie par un vecteur *̅i̅*̅ du repère orthogonal [O ; *̅i̅*̅ ;*̅j̅*̅ ; *̅k̅*̅] La côte ou dimension critique d₁ des motifs 108a, 128a, 108b, 128b, gravés, est inférieure à celle dc de la zone de canal 104a (la dimension critique de la zone active dc étant une dimension mesurée selon une direction parallèle à la direction définie par un vecteur *̅i̅*̅ du repère orthogonal [O ; *̅i̅*̅ ;*̅j̅*̅ ; *̅k̅*̅]. La gravure sélective des motifs 108a, 128a, 108b, 128b, vis-à-vis de la zone semi-conductrice 104a permet également de former des cavités 143 de part et d'autre des motifs 108a, 128a, 108b, 128b (figures 1L et 3C, représentant respectivement, une vue selon la coupe X'X, et une autre vue selon la coupe Y'Y du dispositif microélectronique en cours de réalisation).

On peut ensuite effectuer une étape de dopage des extrémités également appelées « extensions » de la zone semi-conductrice 104b. Par « extrémités » de la zone semi-conductrice 104b, on entend des régions de cette zone semi-conductrice 104b qui ne sont pas situées entre les motifs 108a et 128a de la double grille ou qui dépassent des motifs 108a et 128a de la double grille. Le dopage des extensions peut être effectué par exemple à l'aide d'au moins une implantation. Cette implantation peut être réalisée selon un angle non nul avec une normale au plan principal de la couche isolante 111 (le plan principal de la couche isolante étant défini par un plan passant par cette couche 111 et parallèle au plan [O ; *̅i̅*̅ ; *̅k̅*̅] sur la figure 1L).

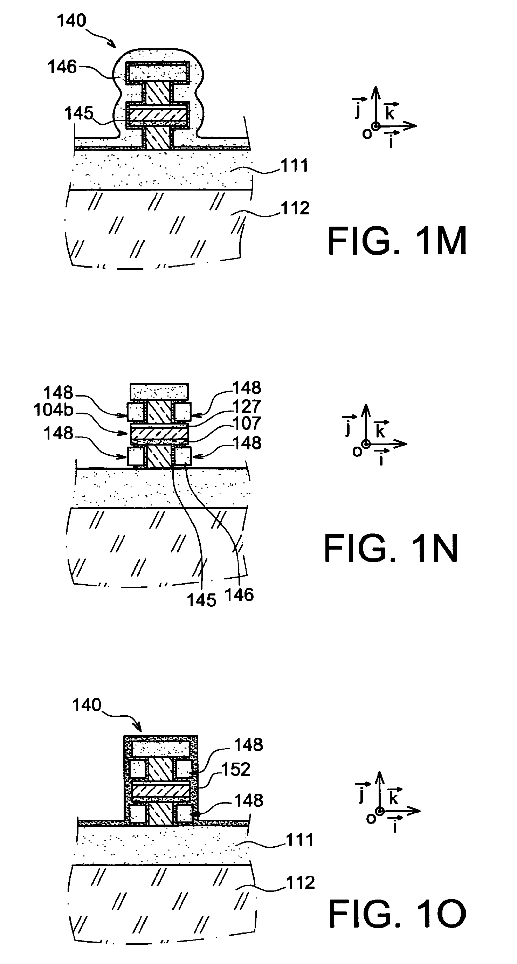

Puis, (figures 1M et 3D représentant respectivement une vue selon la coupe X'X, et une autre vue selon la coupe Y'Y), on forme des zones isolantes ou espaceurs isolants 148, de part et d'autre des motifs 108a, 128a, 108b, 128b, par dépôt d'un ou plusieurs matériaux diélectriques dans les cavités 143.

Ces espaceurs 148 peuvent être réalisés tout d'abord par un dépôt, par exemple conforme, d'une fine couche, par exemple d'épaisseur de l'ordre de 5 nanomètres, à base d'un premier matériau isolant 145, par exemple du SiO₂, puis, par un dépôt, par exemple conforme, d'un deuxième matériau isolant 146 par exemple du Si₃N₄, sur les structures 140 et 142. L'épaisseur du deuxième matériau isolant 146 déposé est choisie de manière à combler les cavités 143. L'épaisseur du deuxième matériau isolant 146 déposé peut être choisie de manière à être supérieure ou égale à la moitié de la hauteur des cavités 143 (la hauteur des cavités 143 étant une dimension définie dans une direction parallèle au vecteur *̅j̅*̅ du repère orthogonal [O ; *̅i̅*̅ ;*̅j̅*̅ ; *̅k̅*̅] sur les figures 1M et 3D).

Une gravure anisotrope du deuxième matériau isolant 146, par exemple à l'aide d'un plasma à base de HBr peut être ensuite réalisée. Puis, on retire en partie le premier matériau isolant 145, de manière à dévoiler la zone semi-conductrice de canal 104b. Ce retrait, peut être réalisé par exemple par gravure à l'aide d'acide fluorhydrique. Suite à ces gravures, des zones isolantes 148 à base du deuxième matériau isolant 146 et du premier matériau isolant 145 sont formées dans lesdites cavités 143, de part et d'autre des motifs 108a, 128a, 108b, 128b (figures 1N et 3E, représentant respectivement une vue selon la coupe X'X, et une vue selon la coupe Y'Y).

Ensuite, on peut former des régions de source et de drain de part et d'autre de la zone semi-conductrice de canal 104b, au niveau des flancs de cette zone semi-conductrice 104b.

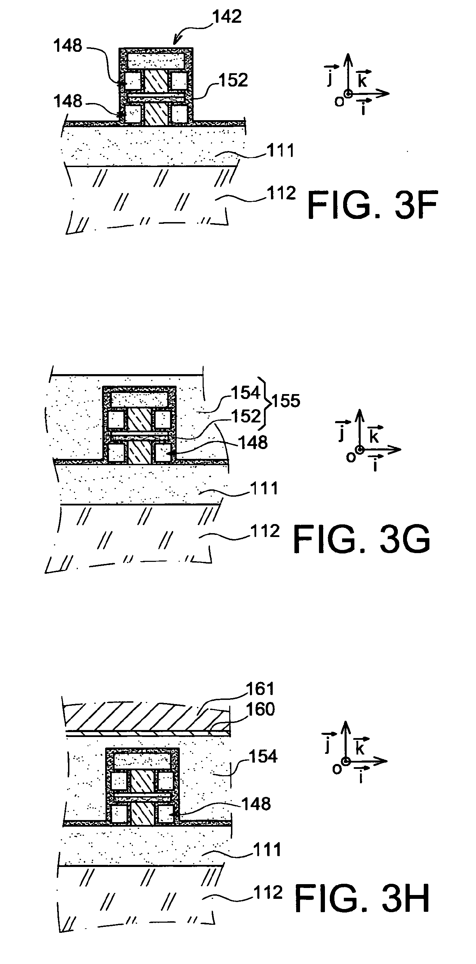

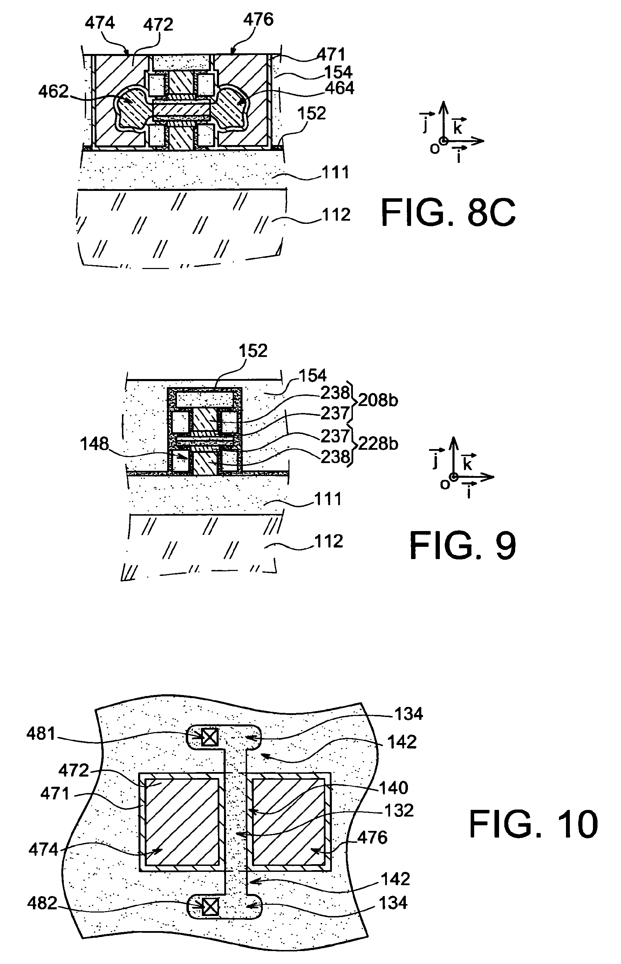

Pour cela on peut tout d'abord effectuer un dépôt d'une fine couche (ou « liner » selon la terminologie anglo-saxonne), qui peut être isolante, par exemple à base de SiO₂ et d'épaisseur de l'ordre de plusieurs nanomètres, par exemple de 5 nanomètres, puis d'une autre couche isolante dite « couche d'arrêt » (non référencée), par exemple à base de Si₃N₄ et d'épaisseur de l'ordre de plusieurs nanomètres, par exemple 30 nanomètres, de manière à former une couche 152, qui peut être isolante et conforme, sur la couche isolante 111 et sur les structures 140 et 142 (figures 10 et 3F, représentant respectivement, une vue selon la coupe X'X, et une vue selon la coupe Y'Y).

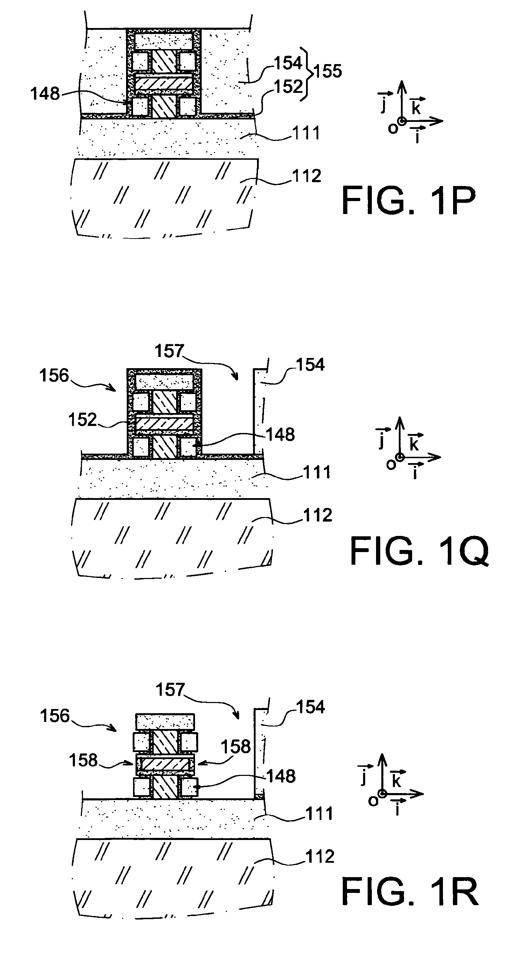

On forme ensuite une couche 154 épaisse, qui peut être isolante et par exemple à base de SiO₂, et d'épaisseur de l'ordre de d'une centaine de nanomètres, par exemple 300 nanomètres. L'épaisseur de la couche 154 est choisie de manière à être au moins égale ou supérieure à la hauteur de la deuxième structure 142, de manière à recouvrir cette dernière (la hauteur de la structure étant une dimension mesurée selon une direction parallèle au vecteur *̅j̅*̅ du repère orthogonal [O ; *̅i̅*̅ ;*̅j̅*̅ ; *̅k̅*̅]. Dans le cas où l'épaisseur de la couche 154 est supérieure à la hauteur de la première structure 140, on peut réduire l'épaisseur de la couche 154 au dessus des structures 140 et 142, jusqu'à atteindre l'épaisseur isolante 152 recouvrant le sommet de la première structure 140, par exemple à l'aide d'une étape de CMP (CMP pour « Chemical Mecanical Polishing » ou polissage mécano-chimique) avec arrêt sur la couche 152 et en particulier sur la couche d'arrêt à base de Si₃N₄ (figures 1P et 3G).

Ensuite (figure 1Q), on forme des cavités 156, 157, dans la couche 154, de part et d'autre de la première structure 140. Les cavités 156, 157, dévoilent la première structure et sont réalisées de manière à former un motif de zone active, qui peut être identique à celui 104a formé dans la couche semi-conductrice 104, lors d'une étape précédemment décrite en liaison avec la figure 1H. Les cavités 156, 157 peuvent être réalisées par exemple par photolithographie et gravure sèche anisotrope, par exemple à l'aide d'un plasma. On retire ensuite dans les cavités 156, 157, la couche isolante 152 recouvrant la structure 140 (figure 1R). Ce retrait peut être effectué à l'aide par exemple d'une gravure à base de H₃PO₄, afin de retirer la fine couche isolante à base de SiO₂, et d'une gravure à base de HF afin de retirer la couche d'arrêt à base de SiO₂. Les cavités 156, 157, formées dans les couches 152 et 154 dévoilent la première structure 140, et en particulier les extrémités de la zone semi-conductrice de canal 104b.

Préalablement à la réalisation des blocs de source et de drain, on peut former des zones conductrices dans une partie des extrémités de la zone semi-conductrice 104b. Pour cela, on peut effectuer une siliciuration d'une partie des extrémités de la zone semi-conductrice 104b. Cette siliciuration peut permettre d'améliorer de futurs contacts d'une part entre une future région de source et la zone semi-conductrice de canal 104b, et d'autre part, entre une future région de drain et la zone semi-conductrice de canal 104b. La siliciuration peut comprendre par exemple un dépôt de nickel sur des parties dévoilées de la structure de canal 104b, puis un recuit de siliciuration, puis un retrait sélectif du Ni non consommé, de manière à former des zones 158 à base de NiSi au niveau d'une partie des extrémités de la zone semi-conductrice 104b (figure 1R).

On peut former ensuite des blocs 164, 166, métalliques de part et d'autre de la première structure 140, destinés à servir de région de source et de région de drain. Pour cela, on peut effectuer un ou plusieurs dépôts de matériaux métalliques dans les cavités 156, 157. La formation des blocs 164, 166 peut comprendre le dépôt d'une fine couche de métal 160, par exemple du TiN, puis le dépôt d'une autre couche 161 de métal, par exemple à base de W, ou de WSi, de part et d'autre de la première structure 140.

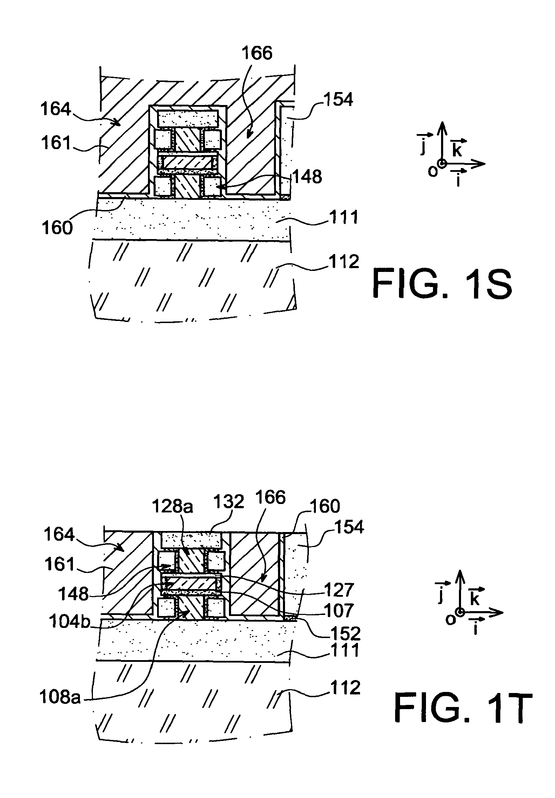

Dans un cas (figures 1S et 3H) où le dépôt des couches 160 et 161 de métal, dépasse de la première structure 140, et/ou que les blocs métalliques 162, 164 sont joints ou reliés entre eux, on peut effectuer un retrait partiel de ces couches 160, 161, notamment au dessus de la première structure 140, afin de former des blocs 162 et 164 métalliques disjoints. Ce retrait partiel peut permet ainsi de supprimer une éventuelle liaison ou un éventuelle court circuit entre les régions de source et de drain. Ce retrait partiel peut être effectué par exemple à l'aide d'une étape de CMP des couches 160 et 161, avec par exemple un arrêt sur le motif isolant 132.

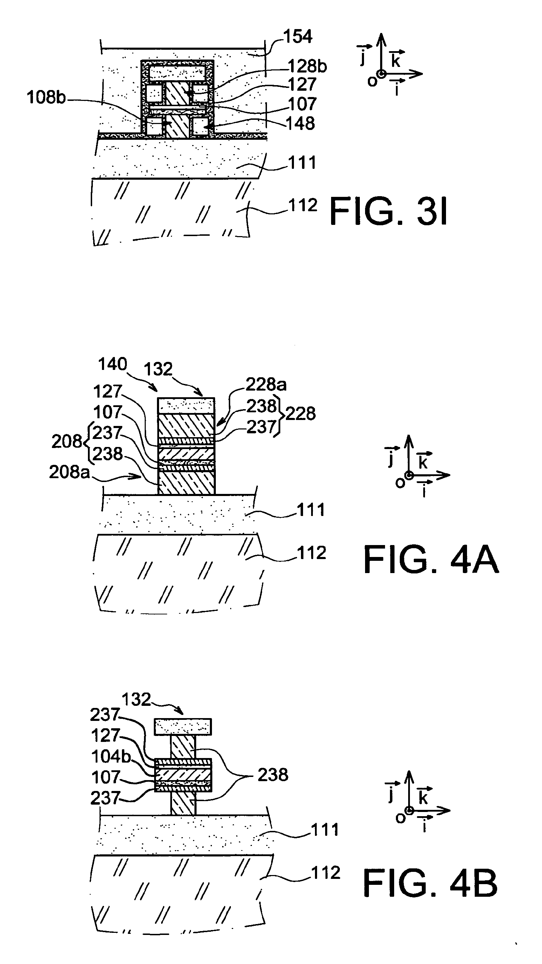

Les figures 1T, 2D, 3F illustrent respectivement une vue selon une coupe X'X, une vue de dessus, et une vue selon une coupe Y'Y, d'un dispositif microélectronique de transistor à double grille, à la suite de la formation des blocs métalliques 164, 166, de source et de drain. Ce dispositif microélectronique comprend au moins une première structure dotée d'une zone semi-conductrice de canal 104b, ainsi que des motifs 108a, 128a, respectivement d'une première grille dite « grille inférieure » et d'une deuxième grille dite « grille supérieure », formées respectivement au-dessus et au-dessous de la zone semi-conductrice 104b. La grille inférieure 108a est séparée de la zone semi-conductrice 104b de canal par l'intermédiaire de la première couche diélectrique de grille 107, tandis que la grille supérieure 128a est séparée de la zone semi-conductrice 104b de canal par l'intermédiaire de la deuxième couche diélectrique de grille 127. La grille supérieure 128a, et la grille inférieure 108a, ont des dimensions critiques ou côtes minimales respectives d₁ égales ou sensiblement égales. La dimension critique d₁ des grilles inférieure et supérieure est inférieure à la dimension critique ou de la côte minimale dc de la zone semi-conductrice de canal 104b. Le dispositif comprend également des blocs 162 et 164 métalliques de source et de drain, formés de part et d'autre de la zone de canal 104b et sont en contact avec les extrémités de cette zone 104b. Les blocs 162 et 164 métalliques de source et de drain sont isolés ou séparés des motifs 108a, 128a de la double grille par l'intermédiaire d'espaceurs isolants 148, formés de part et d'autre des motifs 108a, 128a, contre ces derniers. La première structure 140 peut également comprendre ou être recouverte d'un motif isolant 132 reproduisant la forme du canal (figures 1T et 2D). Le dispositif comprend également une deuxième structure 142 reliée à la première structure 140, et comportant un troisième motif 108b et un quatrième motif 128b, reliés respectivement, au premier motif 108a et au deuxième motif 128a, et à base de matériau de grille. Le troisième motif 108b et le quatrième motif 128b sont séparés par l'intermédiaire de zones à base des diélectriques 107, 127 de grilles (figure 3I).

La deuxième structure pourra servir de zones de prises de contact pour polariser la double grille. Le procédé peut comprendre également, par exemple après la réalisation de zones semi-conductrices de source et de drain, une réalisation sur la deuxième structure, d'au moins un premier contact 181 sur une partie du troisième motif 108b formé de la première couche 108 de matériau de grille, et d'au moins un deuxième contact 182 sur une partie dudit quatrième motif 128b formé de la deuxième couche 128 de matériau de grille, le premier contact 181 n'étant pas connecté ou relié ou en contact avec le quatrième motif 128b, le deuxième contact 182 n'étant pas connecté ou relié ou en contact avec le troisième motif 108b (figure 2E, représentant une vue de dessus du dispositif).

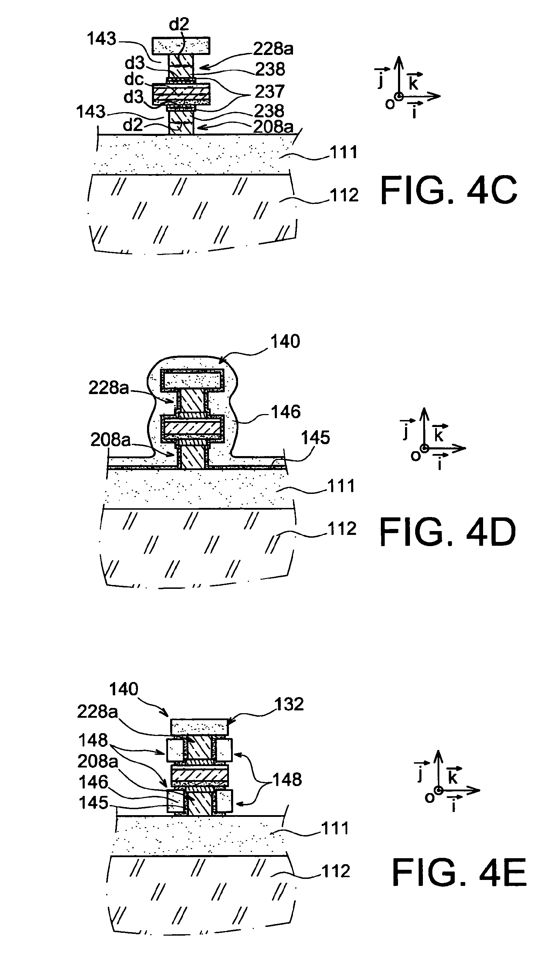

Une variante de l'exemple de procédé précédemment décrit, va à présent être donnée en liaison avec les figures 4A-4E. Dans cette variante, la première couche de matériau de grille et la deuxième couche de matériau de grille sont notées respectivement 208 et 228 et formées chacune d'un empilement de sous-couches de natures différentes ou à base de matériaux différents, par exemple d'un empilement, de deux sous-couches différentes, dit « bicouches ». Lesdits empilements peuvent comprendre une sous-couche à base d'un premier matériau 237 de grille. Le premier matériau 237 de grille peut être choisi pour ses propriétés de conduction de l'électricité, et peut être par exemple un matériau métallique tel que du Ti ou du TiN ou du W ou du WN ou du Ta ou du TaN. L'autre sous-couche peut être à base d'un deuxième matériau 238 de grille. Le deuxième matériau 238 de grille est susceptible d'être gravé sélectivement par rapport à la couche semi-conductrice 104 ou présente une bonne sélectivité de gravure par rapport à la couche semi-conductrice 104. Le deuxième matériau 238 de grille peut être un matériau semi-conducteur. Le deuxième matériau 238 de grille peut être par exemple du polySiGe, notamment dans un cas où la zone semi-conductrice 104a est à base de silicium. La première couche 208 de matériaux 237, 238, de grille et la deuxième couche 228 de matériaux 237, 238, de grille peuvent être formés de bicouches de compositions identiques, mais agencés différemment. Dans la première couche 208 de matériaux de grille, l'agencement du bicouches 237, 238, peut être tel que la sous-couche de premier matériau 237 de grille est en contact avec le premier diélectrique 107 de grille et repose sur la sous-couche de deuxième matériau 238, la sous-couche de deuxième matériau 238 de grille reposant quant à elle sur la couche isolante 111 de support. Dans la deuxième couche 228 de matériaux de grille, l'agencement du bicouches 237, 238, peut être tel que la sous-couche de premier matériau 237 de grille est en contact avec le deuxième diélectrique 127 de grille, tandis que la sous-couche de deuxième matériau 238 de grille repose sur le premier matériau 237 de grille et est en contact avec le motif de masquage 132.

La figure 4A illustre le résultat d'une étape de gravure à travers le motif de masquage 132, semblable à l'étape de gravure illustrée en liaison avec les figures 1J et 1K et décrite précédemment. La gravure réalisée à travers le motif 132, peut être une gravure anisotrope d'un empilement comprenant : la première couche 208 de matériau de grille, la première couche 107 de diélectrique de grille, la zone semi-conductrice 104a, la deuxième couche de diélectrique de grille 127 et la deuxième couche de matériau de grille 228. La gravure dudit empilement est réalisée à travers un masquage comprenant le motif 132 de grille et au moins un motif (non représenté) de zone de prise de contact de grille, de manière à reproduire la forme desdits motifs de masquage dans ledit empilement et à dévoiler la couche isolante 111. Suite à cette gravure, une première structure 140 comportant des motifs 208a, 228a, d'une double grille respectivement sous et sur la zone semi-conductrice 104b de canal, et une deuxième structure (non représentée), comportant des motifs de zones de prises de contact, sont formées.

Puis, on effectue une gravure, partielle des motifs 208a, 228a, de grille, et en particulier d'une partie des motifs 208a, 228a, à base du deuxième matériau 238 des bicouches. Cette gravure peut être une gravure isotrope, par exemple une gravure sèche réalisée à l'aide d'un plasma à base de CF₄. (figure 4B).

Ensuite, on effectue une autre gravure d'une autre partie des motifs 208a, 228a, et en particulier d'une autre partie des motifs 208a, 228a à base premier matériau 237 des bicouches. Cette gravure peut être une gravure isotrope, par exemple réalisée par voie humide, à l'aide par exemple d'une attaque SC2 (figure 4C). L'autre gravure latérale est réalisée de sorte qu'après gravure, les parties des motifs 208a, 228a, à base du premier matériau 237 et les parties des motifs 208a, 228a, à base du deuxième matériau 238, ont des dimensions critiques respectives d₂ et d₃ proches ou qui diffèrent d'au plus 2 nanomètres. Suite à ces gravures, on a réduit la côte ou dimension critique des motifs 208a, 228a, de la double grille, ainsi que celle des motifs de la deuxième structure (non représentée). Des cavités 243, sont formées de part et d'autre des motifs 208a, 228a,. La côte ou dimension critique des motifs 208a, 228a, est inférieure à celle de la zone semi-conductrice de canal 104b. Par rapport à des motifs de double grille formés d'une seule couche de matériau de grille, la mise en oeuvre d'un tel bicouches, permet à la fois, à l'aide du matériau de grille 238, de pouvoir réduire aisément la taille des motifs 208a, 228a par rapport à la zone semi-conductrice de canal, tout en permettant, à l'aide du matériau de grille 237 métallique, d'avoir un contrôle amélioré de la conduction électrique de la zone semi-conductrice 104b de canal (figure 4C).

On peut ensuite, comme cela a été décrit dans l'exemple de procédé précédent, éventuellement effectuer un dopage des extensions. Puis, on peut former des espaceurs isolants 148, de part et d'autre des motifs 208a, 228a, afin d'isoler la double-grille de futures régions de source et de drain. Ces espaceurs 148 peuvent être réalisés de la manière décrite précédemment en liaison avec les figures 1M et 1N, par exemple par dépôt d'un premier matériau isolant 145, par exemple du SiO₂, puis par dépôt conforme d'un deuxième matériau isolant 146, par exemple du Si₃N₄ dans les cavités 143. Puis, une gravure, par exemple anisotrope, du deuxième matériau isolant 146, est effectuée. Ensuite, on effectue un retrait partiel du premier matériau isolant 145, de manière à dévoiler la zone semi-conductrice 104b de canal, et à conserver des zones isolantes 148 à base du premier matériau isolant 145 et du deuxième matériau isolant 146, de part et d'autre des motifs 208a, 228a, (figure 4E). Des étapes de siliciuration de zones de la structure de canal 104b, de formation de blocs, par exemple métalliques, de source et de drain de part et d'autre de la structure de canal 104b, telles que décrites précédemment en liaison avec les figures 1O-1T peuvent être ensuite réalisées pour compléter la formation d'un transistor à double grille.

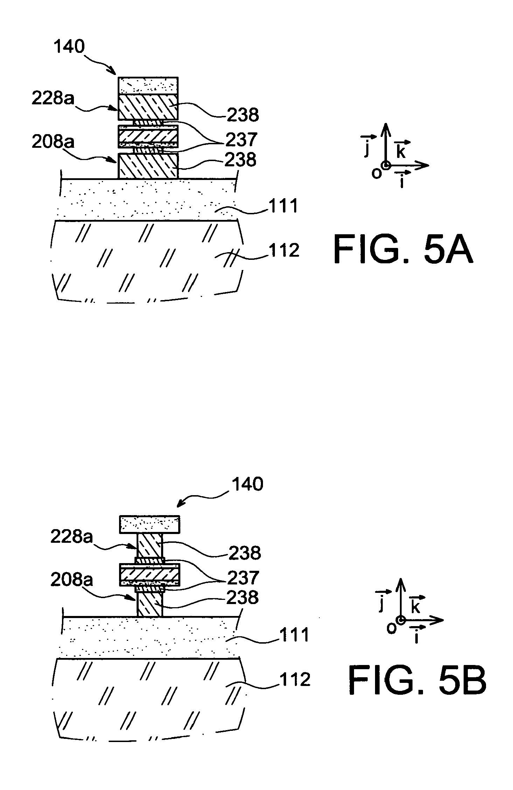

Selon une variante de l'exemple de procédé qui vient d'être décrit en liaison avec les figures 4A à 4E, l'étape de réduction des motifs 208a, 228a, peut être réalisée par une première gravure partielle des parties des motifs 208a, 228a, à base du premier matériau 237 de grille. Cette première gravure partielle peut être une gravure isotrope, réalisée par exemple à l'aide d'une attaque SC2 (figure 5A). Puis, une deuxième gravure partielle, des motifs 208a, 228a et en particulier des parties des motifs 208a, 228a, à base du deuxième matériau 238 des bicouches. Cette deuxième gravure peut être une gravure isotrope, par exemple une gravure sèche réalisée à l'aide d'un plasma à base de CF₄. (figure 5B). Ensuite, on peut compléter la formation d'un transistor double-grille notamment en formant des espaceurs isolants de part et d'autre des motifs 208a, 228a de la double grille, puis des blocs de source et de drain, par exemple métalliques, en contact avec la structure de canal, par exemple comme cela a été décrit précédemment en liaison avec les figures 1L-1T.

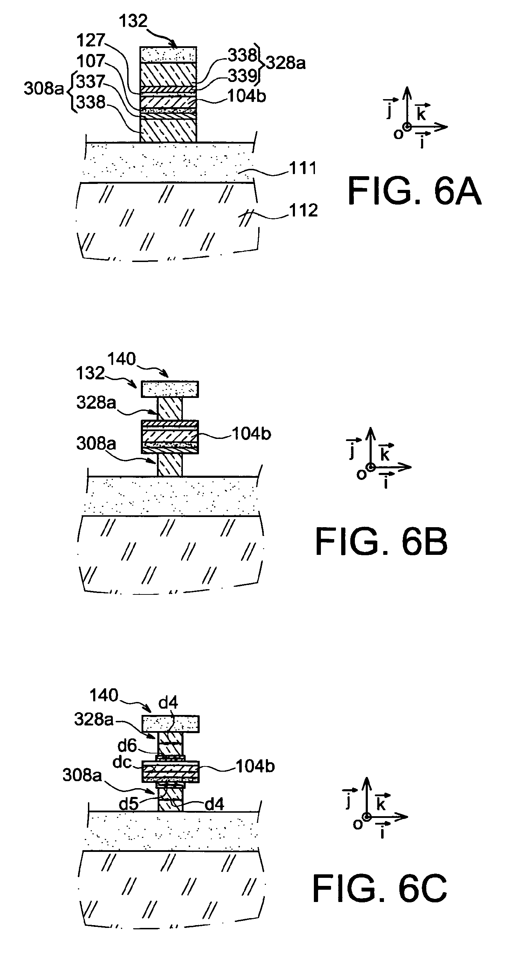

Une autre variante de l'exemple de procédé précédemment décrit en liaison avec les figures 4A-4E, va à présent être donnée en liaison avec les figures 6A-6C. Dans cette variante, la première couche de matériaux de grille et la deuxième couche de matériaux de grille sont notées respectivement 308 et 328 et formées respectivement d'un premier empilement comportant plusieurs sous-couches de matériaux différents, par exemple deux sous-couches de matériaux différents, et d'un deuxième empilement comportant plusieurs sous-couches de matériaux différents, par exemple deux sous-couches de matériaux différents, le deuxième empilement étant différent du premier empilement.

Ledit premier empilement de la première couche 308 de matériaux de grille, peut comprendre une sous-couche à base d'un premier matériau 337 de grille. Le premier matériau 337 de grille peut être choisi pour ses propriétés de conduction de l'électricité. Le premier matériau 337 de grille peut être par exemple un métal tel que du Ti ou du TiN ou du W ou du WN ou du Ta ou du TaN. L'autre sous-couche peut être à base d'un deuxième matériau 338 de grille, susceptible ou apte à être gravé sélectivement par rapport au matériau de la couche semi-conductrice 104. Le deuxième matériau 338 de grille peut être par exemple un matériau semi-conducteur, par exemple du polySiGe, notamment dans un cas où la zone semi-conductrice 104a est à base de silicium. Dans la première couche 308 de matériaux de grille, l'agencement du bicouches de matériaux 337, 338, peut être tel que le premier matériau 337 de grille, est en contact avec le premier diélectrique 107 de grille, tandis que le deuxième matériau 338 de grille repose sur la couche isolante 111 de support. Ledit deuxième empilement de la deuxième couche 328 de matériaux de grille, peut comprendre une sous-couche à base d'un troisième matériau 339 de grille. Le troisième matériau 339 de grille peut être choisi pour ses propriétés de conduction de l'électricité, et peut être, par exemple, un métal différent du premier matériau 337, et choisi par exemple parmi l'un des matériaux suivants : Ti, TiN, W, WN, Ta, TaN. L'autre sous-couche du deuxième empilement peut être à base du deuxième matériau 338 de grille, susceptible d'être gravé sélectivement par rapport au matériau de la couche semi-conductrice 104. Le deuxième matériau 338 de grille peut être par exemple un matériau semi-conducteur, par exemple du polySiGe dans un cas où la zone semi-conductrice 104a est à base de silicium. Dans la deuxième couche 328 de matériaux de grille, l'agencement du bicouches de matériaux 339, 338, peut être tel que le troisième matériau 339 de grille repose sur le deuxième diélectrique 127 de grille, tandis que le deuxième matériau 338 de grille repose sur le troisième matériau 339 de grille.

La figure 6A illustre le résultat d'une étape de gravure, semblable à l'étape de gravure illustrée sur les figures 1J et 1K et décrite précédemment. Cette gravure peut être une gravure anisotrope réalisée à travers les motifs 132 et 134 de la couche de masquage 130, de manière à reproduire la forme desdits motifs 132 et 134 de grille dans ledit empilement et à dévoiler la couche isolante 111. La gravure anisotrope peut être réalisée par exemple à l'aide de Cl₂ (+ O₂) ou HBr (+ O₂) et/ou BCl₃ et permet de former une première structure 140 comportant des motifs 308a, 328a, d'une double grille respectivement sous et sur la zone semi-conductrice 104b de canal, et une deuxième structure comportant des motifs de prise de contact de grille.

Puis, on effectue une gravure partielle, du deuxième matériau 338 des bicouches, de manière à réduire les parties des motifs 308a, 328a, de grille qui sont à base du deuxième matériau diélectrique 338. Cette gravure peut être une gravure sèche, réalisée par exemple à l'aide d'un plasma CF₄ (figure 6B).

Ensuite, on effectue une deuxième gravure partielle, du premier matériau 337 et du troisième matériau 339 de grille, de manière à réduire les parties du motif 308a, qui sont à base du premier matériau 337 et à réduire les parties du motif 328a, qui sont à base du deuxième matériau 339. Cette gravure peut être une gravure, réalisée par exemple à l'aide de SC2 (figure 6C). La durée de cette deuxième gravure peut être ajustée de sorte qu'à la fin de la deuxième gravure, les parties des motifs 328a, 308a, à base du deuxième matériau 338 de grille, ont une dimension critique d₄ proche de la dimension critique d₅ des parties du motifs 308a, à base du premier matériau 337 de grille, et proche de la dimension critique d₆ des parties du motif 328a, à base du troisième matériau 339 de grille. Par dimensions critiques « proches », on entend qui diffèrent d'au plus 2 nanomètres.

Ensuite, on peut compléter la formation d'un transistor double-grille notamment en formant des espaceurs isolants de part et d'autre des motifs 308a, 328a de la double grille, puis éventuellement en effectuant une siliciuration de la zone semi-conductrice 104b de canal, puis en formant des blocs de source et de drain, par exemple métalliques, en contact avec la structure de canal, par exemple comme cela a été décrit précédemment en liaison avec les figures 1L-1T.

Une variante de formation de blocs de source et de drain pour un transistor à double grille, comportant une structure de double grille, va à présent être donnée. Pour cette variante, on forme un dispositif par exemple tel que décrit précédemment en liaison avec la figure 4E.

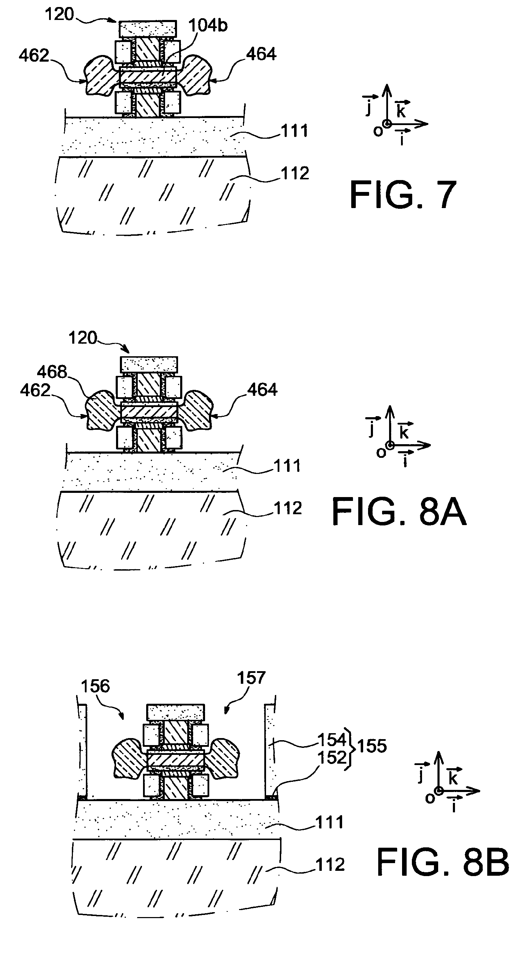

On forme ensuite, de part et d'autre de la première structure 140, au niveau des extrémités de la zone semi-conductrice 104b de canal, des blocs semi-conducteurs 462 et 464. Ces blocs semi-conducteurs 462, 464, peuvent être formés par croissance par épitaxie sur les bords ou extrémités de la zone semi-conductrice de canal 104b et sont destinés à former respectivement une région de source et une région de drain ou à appartenir respectivement à une future région de source et à une future région de drain. Selon une première possibilité, les blocs semi-conducteurs 462, 464, peuvent être formés à base du même matériau semi-conducteur que la zone semi-conductrice de canal 104b, par exemple du Si dans un cas où la zone semi-conductrice de canal 104b est à base de Si (figure 7). Selon une mise en oeuvre avantageuse, les blocs semi-conducteurs 462, 464, peuvent être formés à base d'un matériau semi-conducteur 468 différent de celui de la zone semi-conductrice de canal 104b, par exemple du Ge ou du SiGe, notamment dans un cas où la zone semi-conductrice de canal 104b est à base de Si (figure 8A). Après formation des blocs semi-conducteurs 462, 464, il est possible de compléter la formation des régions de source et de drain, par exemple par un procédé semblable à celui décrit précédemment en liaison avec les figures 1O-1T. On forme tout d'abord une couche 155 de manière à recouvrir les structures 140 et 142. Ladite couche 155 peut être formée par dépôt d'une fine couche isolante (« liner »), par exemple à base de SiO₂ puis d'une autre couche isolante dite « couche d'arrêt », par exemple à base de Si₃N₄, (le liner et la couche d'arrêt étant référencées 152) puis d'une couche isolante 154 épaisse, par exemple à base de SiO₂. Ensuite (figure 8B), on forme des cavités 156, 157 dans la couche 155 dévoilant la première structure 140, de part et d'autre de cette dernière. On forme ensuite des blocs 474, 476, métalliques de part et d'autre la première structure 140, et autour des blocs semi-conducteurs 462, 464. Pour cela, on peut effectuer un ou plusieurs dépôts de matériaux métalliques dans les cavités 156, 157. Pour former les blocs 474, 476, métalliques, on peut tout d'abord effectuer par exemple un dépôt d'une fine couche à base d'un premier matériau métallique 471, par exemple du TiN, sur les parois et dans le fond des cavités 156, 157, la fine couche de matériau métallique 471 étant en contact avec la première structure et en particulier avec les blocs semi-conducteurs 462 et 464. On peut ensuite effectuer par exemple un dépôt d'un deuxième matériau métallique 472, par exemple du W, dans les cavités 156, 157. Dans un cas où les matériaux métalliques 471, 472 dépassent de la première structure 140, et/ou que les blocs métalliques 474, 476, sont joints ou reliés entre eux, on peut effectuer un retrait partiel du ou des matériau(x) 160, notamment au dessus de la première structure 140, afin de former des blocs 474 et 476 métalliques disjoints. Ce retrait partiel peut être effectué par exemple à l'aide d'une étape de CMP (figure 8C). Le dispositif formé peut comprendre également une deuxième structure 142 de zones de prises de contacts de grille, reposant sur la couche isolante 111 du support 112, et reliée à la première structure 140. La deuxième structure 142 comporte un troisième motif 208b et un quatrième motif 228b, reliés respectivement, au premier motif 208a et au deuxième motif 228a de la première structure. Le troisième motif 208b est formé du même empilement de couches 238, 237 que le premier motif 208a, tandis que le quatrième motif 228b, est formé du même empilement de couches 237, 238, que le deuxième motif 228a (figure 9). Le procédé peut comprendre également, après la réalisation de zones de source et de drain, une réalisation sur la deuxième structure 142, de contacts métalliques d'au moins un premier contact métallique 481 en contact avec une zone du troisième motif 208b, et d'au moins un deuxième contact métallique 482 en contact avec une zone du quatrième motif 228b. Le premier contact 481 peut être formé de manière à être en contact avec le troisième motif 208b sans être en contact avec le quatrième motif 228b. Le deuxième contact 482 peut être formé de manière à être en contact avec le quatrième motif 228b sans être en contact avec le quatrième motif 228b (figure 10). Le premier contact 481 peut être réalisé par exemple à l'aide d'étapes de formation d'un masquage, puis de gravure à travers ce masquage afin de former une cavité dévoilant le troisième motif 208b et ne dévoilant pas le quatrième motif 228b, puis de remplissage de la cavité par au moins un matériau métallique. Le deuxième contact 482 peut être réalisé par exemple à l'aide d'étapes de formation d'un autre masquage, puis de gravure à travers cet autre masquage afin de former une autre cavité dévoilant le quatrième motif 228b mais ne dévoilant pas le troisième motif 208b, puis de remplissage de l'autre cavité par au moins un matériau métallique.

## Revendications

1. Procédé de réalisation d'un dispositif microélectronique doté d'au moins une structure de double grille pour transistor, comprenant les étapes de :
a) formation d'au moins un empilement comprenant au moins une première couche (108,208,308) de matériau(x) de grille, au moins une première couche de diélectrique (107) de grille reposant sur la première couche de matériau(x) de grille, au moins une zone semi-conductrice (104a) reposant sur ladite première couche de diélectrique de grille, au moins une deuxième couche de diélectrique (127) de grille reposant sur ladite zone semi-conductrice et sur ladite première couche de diélectrique de grille, et au moins une deuxième couche (128,228,328) de matériau(x) de grille reposant sur la deuxième couche de diélectrique de grille,
b) gravure anisotrope dudit empilement à travers un masquage, de manière à réaliser en regard de la zone semi-conductrice, au moins une première structure comportant une zone semi-conductrice (104b) dite « de canal » formée à partir de ladite zone semi-conductrice (104a) gravée, au moins un premier motif (108a, 208a, 308a) d'une première grille formé à partir de la première couche de matériau de grille gravée et au moins un deuxième motif (128a,228a,328a) d'une deuxième grille formée à partir de la deuxième couche de matériau de grille gravée,
c) gravure isotrope, d'au moins une partie du premier motif et d'au moins une partie du deuxième motif, sélective vis-à-vis de la zone semi-conductrice de canal.

2. Procédé selon la revendication 1, ladite première couche (208,308) de matériaux de grille étant formée d'un empilement de plusieurs sous-couches de matériaux (237,238,337,338) différents.

3. Procédé selon la revendication 1 ou 2, ladite deuxième couche (228,328) de matériaux de grille étant formée d'un empilement de plusieurs sous-couches de matériaux (237,238,338,339) différents.

4. Procédé selon la revendication 1 à 3, dans lequel ladite première couche (208,308) de matériaux de grille est formée d'un premier empilement de plusieurs sous-couches de matériaux différents et la deuxième couche (228,328) de matériaux de grille est formée d'un deuxième empilement de plusieurs sous-couches de matériaux différents, le premier empilement étant différent du deuxième empilement ou/et comprenant au moins un matériau différent de celui du premier empilement.

5. Procédé selon l'une des revendications 1 à 4, la première couche (108,208,308) de matériau(x) de grille ou/et la deuxième couche (128,228,328) de matériau(x) de grille comprenant au moins un matériau semi-conducteur (338,238).

6. Procédé selon la revendication 5, la gravure isotrope à l'étape c) comprenant au moins une étape de gravure sèche dudit matériau semi-conducteur à l'aide d'un plasma.

7. Procédé selon l'une des revendications 5 ou 6, ledit matériau semi-conducteur étant du polySiGe.

8. Procédé selon l'une des revendications 1 à 7, la première couche (208,308) de matériau(x) de grille ou/et la deuxième couche (228,328) de matériaux de grille comprenant au moins une sous-couche à base d'au moins un matériau métallique (339,337,237).

9. Procédé selon la revendication 8, la gravure isotrope comprenant à l'étape c) au moins une étape de gravure humide de ladite ou desdites sous-couches à base de matériau métallique.

10. Procédé selon l'une des revendications 1 à 9, ladite zone semi-conductrice (104a) étant à base de silicium.

11. Procédé selon l'une des revendications 1 à 10, comprenant après l'étape c), la formation d'espaceurs isolants (148) de part et d'autre du premier motif (108a,208a,308a) de la première grille et de part et d'autre du deuxième motif (128a,228a,328a) de la deuxième grille.

12. Procédé selon l'une des revendications 1 à 11, comprenant en outre, après l'étape c), la formation d'au moins une première zone (164, 462, 474) destinée à jouer le rôle de région de source, en contact avec la zone semi-conductrice de canal, et d'au moins une deuxième zone, destinée à jouer le rôle de région de drain (166,464,476), en contact avec la zone semi-conductrice (104b) de canal.

13. Procédé selon la revendication 12, la formation de ladite première zone et de ladite deuxième zone comprenant la croissance par épitaxie de blocs semi-conducteurs (462,464) sur les flancs de la zone semi-conductrice (104b) de canal.

14. Procédé selon la revendication 13, les blocs semi-conducteurs étant à base d'un matériau semi-conducteur (470) différent de celui ou de ceux de la zone semi-conductrice de canal (104b).

15. Procédé selon l'une des revendications 12 à 14, la formation de ladite première zone de région de source et de ladite deuxième zone de région de drain comprenant les étapes de :
- dépôt d'au moins une couche (155) sur le support,
- réalisation dans ladite couche (155) de cavités (156,157) de part et d'autre de ladite première structure (140),
- dépôt d'un ou plusieurs matériaux métalliques (160,161) dans les cavités, de manière à former au moins un premier bloc métallique (164,472) et au moins un deuxième bloc métallique (166,474) de part et d'autre de la zone semi-conductrice de canal.

16. Procédé selon l'une des revendications 1 à 15, la formation dudit empilement comprenant des étapes de :
- dépôt de la première couche (108,208) de diélectrique de grille sur une couche semi-conductrice (104) reposant sur une couche isolante (102) recouvrant un premier support (101),
- dépôt de la première couche de matériaux de grille sur ladite première couche (108,208,308) de diélectrique de grille,
- collage d'un deuxième support (111-112) sur la première couche de matériau(x) de grille,
- retrait du premier support et d'une partie de ladite couche isolante recouvrant le premier support,
- gravure de ladite couche semi-conductrice (104) de manière à former ladite zone semi-conductrice (104b),
- dépôt de la deuxième couche de diélectrique de grille sur ladite zone semi-conductrice et sur la couche isolante (102),
- dépôt de la deuxième couche de matériau(x) de grille sur la deuxième couche de diélectrique de grille.

17. Procédé selon l'une des revendications 1 à 16, dans lequel l'étape b) de gravure anisotrope comprend en outre : la réalisation d'au moins une deuxième structure (142) dans une zone de l'empilement dans laquelle la deuxième couche de diélectrique (127) de grille repose sur la première couche de diélectrique (107) de grille, la deuxième structure comportant au moins un troisième motif (108b,208b) formé de la première couche (108,208) de matériau(x) de grille gravée et au moins un quatrième motif (128b,228b) formé de la deuxième couche (128,228) de matériau(x) de grille gravée, le troisième motif (108b,208b) et le quatrième motif (128b,228b) étant séparés par l'intermédiaire des couches (107,127) de diélectriques de grille.

18. Procédé selon la revendication 17, comprenant en outre : la réalisation sur la deuxième structure (142), d'au moins un premier contact métallique (181,481), en contact avec ledit troisième motif (108b,208b) sans être en contact avec ledit quatrième motif (128b,228b), et au moins un deuxième contact métallique (182,482), en contact avec le quatrième motif (128b,228b), sans être en contact avec ledit troisième motif (108b,208b).

## Claims

1. Method for making a microelectronic device provided with at least one double gate structure for a transistor, including the following steps:
a) formation of at least one stack comprising at least one first layer (108,208,308) of gate material(s), at least one first gate dielectric layer (107) supported on the first layer of gate material(s), at least one semiconducting zone (104a) supported on said first gate dielectric layer (127), at least one second gate dielectric layer supported on said semiconducting zone and on said first gate dielectric layer, and at least one second layer of gate material(s) supported on the second gate dielectric layer,
b) anisotropic etching of said stack through a mask, so as to make at least one first structure facing the semiconducting zone (104b), comprising a so-called « channel » semiconducting zone (104a) formed from said etched semiconducting zone, at least one first pattern (108a, 208a, 308a) of a first gate formed from the first etched layer of gate material, and at least one second pattern of a second gate formed from the second etched layer of gate material,
c) isotropic etching of at least part of the first pattern and at least part of the second pattern, selectively with regard to the channel semiconducting zone.

2. Method according to claim 1, said first layer (208, 308) of gate materials being formed from a stack of several sub layers of different materials (237, 238, 337, 338).

3. Method according to claim 1 or 2, said second layer (228, 328) of gate materials being formed from a stack of several sub layers of different materials (237, 238, 337, 338).

4. Method according to any of claims 1 to 3, in which said first layer (208, 308) of gate materials is formed from a first stack of several sub layers of different materials and the second layer (228, 328) of gate materials is formed from a second stack of several sub layers of different materials, the first stack being different from the second stack and/or comprising at least one material different from the material from which the first stack is formed.

5. Method according any of claims 1 to 4, the first layer (108, 208, 308) of gate material(s) and/or the second layer (128, 228, 328) of gate material(s) comprising at least one semiconducting material.

6. Method according to claim 5, the isotropic etching in step c) including at least one dry etching step of said semiconducting material using a plasma.

7. Method according to claim 5 or 6, said semiconducting material being polySiGe.

8. Method according any of claims 1 to 7, the first layer (208, 308) of gate material(s) and/or the second layer (238, 328) of gate materials comprising at least one sub layer based on at least one metallic material.

9. Method according to claim 8, isotropic etching in step c) including at least one wet etching step of said sub layer(s) based on metallic material.

10. Method according any of claims 1 to 8, said semi-conducting zone (104a) being based on silicon.

11. Method according any of claims 1 to 10, comprising after step c), the formation of insulating spacers on each side of the first pattern in the first gate and on each side of the second pattern in the second gate.

12. Method according to any of claims 1 to 11, also comprising, after step c), the formation of at least one first zone (164, 462, 474) to act as a source region in contact with the channel semiconducting zone, and at least one second zone (166, 464, 476) to act as drain region, in contact with the channel semiconducting zone.

13. Method according to claim 12, wherein formation of said first and second zones including epitaxial growth of semiconducting blocks (462, 464) on the sides of the channel semiconducting zone (104b).

14. Method according to claim 13, the semi-conducting blocks being based on a semiconducting material different from the semiconducting material(s) in the channel semiconducting zone.

15. Method according any of claims 12 to 14, formation of said first source region zone and said second drain region zone including the following steps:
- deposition of at least one layer (155) on the support,
- production of cavities in said layer (155) on each side (156, 157) of said first structure (140),
- deposition of one or several metallic materials (160, 161) in the cavities, so as to form at least one first metallic block (164, 472) and at least one second metallic block (166, 474) on each side of the channel semi-conducting zone.

16. Method according any of claims 1 to 15, formation of said stack including the following steps:
- deposit the first gate dielectric layer (108, 208) on a semi-conducting layer supported on an insulating layer (102) covering a first support (101),
- deposit the first layer of gate material(s) on said first gate dielectric layer (108, 208,308),
- bond a second support (111-112) onto the first layer of gate material(s),
- remove the first support and part of said insulating layer covering the first support,
- etch said semiconducting layer (104) so as to form said semiconducting zone (104b),
- deposit the second layer of gate dielectric on said semiconducting zone and on the dielectric layer (102),
- deposit the second layer of gate material(s) on the second gate dielectric layer.

17. Method according any of claims 1 to 16, in which anisotropic etching step b) also includes: making at least one second structure (142) in a zone of the stack in which the second gate dielectric layer (127) is supported on the first gate dielectric layer (107), the second structure comprising at least one third pattern (108b, 208b) formed from the first etched layer of gate material(s) and at least one fourth pattern formed from the second etched layer of gate materials, the third pattern and the fourth pattern (128b, 228b) being separated by gate dielectric layers (107, 217).

18. Method set forth in claim 17, also including: formation of at least one first metallic contact (181, 481) on the second structure (142), in contact with said third pattern (108b, 208b) without being in contact with said fourth pattern (128b, 228b), and at least one second metallic contact (182, 482), in contact with the fourth pattern (128b, 228b), without being in contact with said third pattern (108b, 208b).

## Patentansprüche

1. Verfahren zur Herstellung einer mikroelektronischen Vorrichtung mit wenigstens einer Doppelgate-Transistorstruktur, die folgenden Schritte umfassend:
a) Ausbildung wenigstens eines Stapels mit wenigstens einer ersten Schicht (108,208,308) aus Gate-Material(ien), wenigstens einer auf der ersten Schicht aus Gate-Material(ien) ruhenden ersten Gate-Dielektrikumsschicht (107), wenigstens einer auf der genannten ersten Gate-Dielektrikumsschicht ruhenden Halbleiterzone (104a), wenigstens einer auf der genannten Halbleiterzone und auf der ersten Gate-Dielektrikumsschicht ruhende zweiten Gate-Dielektrikumsschicht (127), und wenigstens einer auf der zweiten Gate-Dielektrikumsschicht ruhenden zweiten Schicht (128,228,328) aus Gate-Material(ien),
b) Anisotrope Ätzung des genannten Stapels durch eine Maske hindurch, um gegenüber der Halbleiterzone wenigstens eine erste Struktur mit einer sogenannten Kanal-Halbleiterzone (1 04b), gebildet aus der genannten geätzten Halbleiterzone (1 04a), wenigstens ein erstes Muster (108a, 208a, 308a) eines ersten Gates, gebildet aus der ersten geätzten Gate-Materialschicht, und wenigstens ein zweites Muster (128a, 228a, 328a), gebildet aus der zweiten geätzten Gate-Materialschicht, zur realisieren,
c) Anisotrope Ätzung wenigstens eines Teils des ersten Musters und wenigstens eines Teils des zweiten Musters, selektiv gegenüber der Kanal-Halbleiterzone.

2. Verfahren nach Anspruch 1, wobei die erste Gate-Materialschicht (208,308) durch einen Stapel von mehreren Teilschichten aus unterschiedlichen Materialien (237,238,337,338) gebildet wird.

3. Verfahren nach Anspruch 1 oder 2, wobei die genannte zweite Gate-Materialschicht (228,328) durch einen Stapel von mehreren Teilschichten aus unterschiedlichen Materialien (237, 238,338,339) gebildet wird.

4. Verfahren nach Anspruch 1 bis 3, bei dem die erste Gate-Materialschicht (208,308) durch einen ersten Stapel von mehreren Teilschichten aus unterschiedlichen Materialien und die zweite Gate-Materialschicht (238,328) durch einen zweiten Stapel von mehreren Teilschichten aus unterschiedlichen Materialien gebildet wird, wobei der erste Stapel sich von dem zweiten Stapel unterscheidet und/oder wenigstens ein Material aufweist, das anders ist als das des ersten Stapels.

5. Verfahren nach einem der Ansprüche 1 bis 4, wobei die erste Schicht (108,208,308) aus Gate-Material(ien) und/oder die zweite Schicht (128,228,328) aus Gate-Material(ien) wenigstens ein Halbleitermaterial (338,238) umfassen.

6. Verfahren nach Anspruch 5, wobei die isotrope Ätzung in Schritt c) wenigstens einen Trockenätzungsschritt des genannten Halbleitermaterials mit Hilfe eines Plasmas umfasst.

7. Verfahren nach einem der Ansprüche 5 oder 6, wobei das genannte Halbleitermaterial PolySiGe ist.

8. Verfahren nach einem der Ansprüche 1 bis 7, wobei die erste Schicht (208,308) aus Gate-Material(ien) und/oder die zweite Schicht (228,328) aus Gate-Materialien wenigstens eine Teilschicht auf der Basis von wenigstens einem metallischen Material (339,337,237) umfassen.

9. Verfahren nach Anspruch 8, wobei die isotrope Ätzung in Schritt c) wenigstens einen Nassätzungsschritt der genannten Teilschicht(en) auf der Basis von metallischem Material umfasst.

10. Verfahren nach einem der Ansprüche 1 bis 9, wobei die genannte Halbleiterzone (104a) auf Siliciumbasis beruht.

11. Verfahren nach einem der Ansprüche 1 bis 10, umfassend, nach Schritt c), die Ausbildung von isolierenden Abstandselementen (148) beiderseits des ersten Musters (108a,208a,308a) des ersten Gates und beiderseits des zweiten Musters (128a,228a,328a) des zweite Gates.

12. Verfahren nach einem der Ansprüche 1 bis 11, außerdem umfassend, nach Schritt c), die Bildung wenigstens einer ersten Zone (164,462,474), dazu bestimmt, die Rolle des Source-Bereichs zu spielen, in Kontakt mit der Kanal-Halbleiterzone, und wenigstens einer zweiten Zone (166,464,476), dazu bestimmt, die Rolle des Drain-Bereichs zu spielen, in Kontakt mit der Kanal-Halbleiterzone.

13. Verfahren nach Anspruch 12, wobei die Bildung der genannten ersten Zone und der genannten zweiten Zone das Epitaxie-Wachstum von Halbleiterblöcken (462,464) auf den Flanken der Kanal-Halbleiterzone (104b) umfasst.

14. Verfahren nach Anspruch 13, wobei die Halbleiterblöcke auf der Basis eines Halbleitermaterials (470) beruhen, das sich von demjenigen oder denjenigen der Kanal-Halbleiterzone (104b) unterscheidet.

15. Verfahren nach einem der Ansprüche 12 bis 14, wobei die Bildung der genannten ersten Zone des Source-Bereichs und der genannten zweiten Zone des Drain-Bereichs folgende Schritte umfasst:
- Abscheidung wenigstens einer Schicht (155) auf dem Träger,
- Realisierung, in der genannten Schicht (155), von Hohlräumen (156,157) beiderseits der genannten ersten Struktur (140),
- Abscheidung von einem oder von mehreren metallischen Materialien (160,161) in den Hohlräumen, um beiderseits der Kanal-Halbleiterzone wenigstens einen ersten Metallblock (164,472) und wenigstens einen zweiten Metallblock (106,474) auszubilden.

16. Verfahren nach einem der Ansprüche 1 bis 15, wobei die Bildung des genannten Stapels folgende Schritte umfasst:
- Abscheiden der ersten Gate-Dielektrikumsschicht (108,208) auf einer Halbleiterschicht (104), ruhend auf einer einen ersten Träger (101) bedeckenden Isolierschicht (102),
- Abscheiden der ersten Schicht aus Gate-Materialien auf der genannten ersten Gate-Dielektrikumsschicht (108,208,308),
- Festkleben des zweiten Trägers (111-112) auf der ersten Schicht aus Gate-Material(ien),
- Entfernen des ersten Trägers und eines Teils der genannten den ersten Träger bedeckenden Isolierschicht,
- Ätzen der genannten Halbleiterschicht (104), um die genannte Halbleiterzone (104b) auszubilden,
- Abscheiden der zweiten Gate-Dielektrikumsschicht auf der genannten Halbleiterzone und auf der Isolierschicht (102),
- Abscheiden der zweiten Schicht aus Gate-Material(ien) auf der zweiten Gate-Dielektrikumsschicht.

17. Verfahren nach einem der Ansprüche 1 bis 16, bei dem der Anisotropieätzungs-Schritt b) außerdem umfasst: die Realisierung wenigstens einer zweiten Struktur (142) in einer Zone des Stapels, in der die zweite Gate-Dielektrikumsschicht (127) auf der ersten Gate-Dielektrikumsschicht (107) ruht, wobei die zweite Struktur wenigstens ein drittes Muster (108b,208b) umfasst, gebildet aus der ersten geätzten Schicht (108,208) aus Gate-Material(ien), und wenigstens ein viertes Muster (128b,228b) umfasst, gebildet aus der zweiten geätzten Schicht (128,228) aus Gate-Material(ien), wobei das dritte Muster (108b,208b) und das vierte Muster (128b,228b) durch Gate-Dielektrikumsschichten (107,127) getrennt sind.

18. Verfahren nach Anspruch 17, außerdem umfassend: die Realisierung, in bzw. auf der zweiten Struktur (142), wenigstens eines ersten metallischen Kontakts (181,481) in Kontakt mit dem genannten dritten Muster (108b,208b), ohne Kontakt mit dem genannten vierten Muster (128b, 228b) zu haben, und wenigstens eines zweiten metallischen Kontakts (182,482) in Kontakt mit dem vierten Muster (128b,228b), ohne Kontakt mit dem genannten dritten Muster (1 08b,208b) zu haben
